## Europäisches Patentamt

## European Patent Office

## Office européen des brevets

(11) Veröffentlichungsnummer: **0 096 090**
**B1**

(12) **EUROPÄISCHE PATENTSCHRIFT**

(45) Veröffentlichungstag der Patentschrift:
**08.01.86**

(51) Int. Cl.⁴: **G 03 F 3/08**

(21) Anmeldenummer: **82104918.6**

(22) Anmeldetag: **04.06.82**

(54) **Verfahren und Einrichtung zur Herstellung farbiger Proofs beim Mehrfarbendruck.**

(43) Veröffentlichungstag der Anmeldung:
**21.12.83 Patentblatt 83/51**

(45) Bekanntmachung des Hinweises auf die Patenterteilung:
**08.01.86 Patentblatt 86/2**

(84) Benannte Vertragsstaaten:
**AT BE CH DE FR GB IT LI NL SE**

(56) Entgegenhaltungen:
**DE - A - 2 632 003**
**DE - A - 2 920 058**
**DE - A - 3 047 633**

(73) Patentinhaber: **DR.-ING. RUDOLF HELL GmbH,**
**Grenzstrasse 1-5, D-2300 Kiel 14 (DE)**

(72) Erfinder: **Jung, Eggert, Mühlenberg 25,**
**D-2306 Schönberg (DE)**
Erfinder: **Roes, Christian, Starnberger Strasse 92,**
**D-2300 Kiel 14 (DE)**
Erfinder: **Wigger, Andreas, Ostring 190,**
**D-2300 Kiel 14 (DE)**
Erfinder: **Ziemen, Ernst-August, Plöner Strasse 62,**
**D-2300 Kiel 14 (DE)**

ACTORUM AG

## Beschreibung

Die Erfindung bezieht sich auf die elektronische Reproduktionstechnik für den Mehrfarbendruck, insbesondere auf die Herstellung von Farbbildern und Proofs zur Qualitätskontrolle vor dem eigentlichen Druckprozess.

Bei der elektronischen Reproduktion farbiger Vorlagen werden in einem Farbscanner durch punkt- und zeilenweise, trichromatische Vorlagen-Abtastung und optoelektronische Wandlung des Abtastlichtes drei primäre Farbmesswertsignale gewonnen, welche ein Mass für die Farbanteile Rot, Grün und Blau der abgetasteten Bildpunkte sind. Ein Farbkorrektur-Rechner korrigiert die Farbmesswertsignale und erzeugt im Falle des Vierfarbendruckes vier Farbauszugssignale für die Farbauszüge Gelb, Magenta, Cyan und Schwarz. Die Farbauszugssignale geben die beim Druck erforderlichen Mengen an Gelb-, Magenta-, Cyan- und Schwarz-Druckfarbe an.

Von den farbkorrigierten Farbauszugssignalen werden dann die Druckformen für den Druck hergestellt.

In Auflagendruckmaschinen für die betreffenden Druckverfahren erfolgt dann der Übereinanderdruck der mit den vier Druckfarben eingefärbten Druckformen auf das Auflagenpapier.

Um das zu erwartende Druckergebnis, insbesondere hinsichtlich der Farbe, bereits vor dem eigentlichen Auflagendruck kontrollieren und gegebenenfalls noch Korrekturen an den Druckformen vornehmen zu können, werden vor dem Auflagendruck von den Druckformen Andrucke mit speziellen Andruckmaschinen hergestellt. Solche Andrucke lassen sich somit nur herstellen, wenn die Druckformen bereits vorhanden sind.

Eine im Reproduktionsprozess zeitlich noch vor der Druckform-Herstellung liegende Kontrollmöglichkeit für das Endprodukt bieten die Farb-Prüfverfahren, mit denen auf fotografischem Wege farbige Kontrollbilder angefertigt werden können. Ausserdem ist es dem Fachmann anhand der Farbauszüge möglich, bereits Rückschlüsse auf den farblichen Eindruck des Endproduktes zu ziehen und die Farbauszüge noch entsprechend zu korrigieren. Diese Kontrollmöglichkeiten entfallen aber bei modernen Reproduktionssystemen, da die Herstellung von Farbauszügen auf Filmmaterial als Zwischenschritt zur Druckform entfällt, und statt dessen eine rein datenmässige Verarbeitung einer Vorlage bis zur Druckform erfolgt.

Zur Farbkontrolle vor der Druckform-Herstellung können auch sogenannte Farbsichtgeräte verwendet werden, bei denen das spätere Ergebnis des Mehrfarbendrucks auf einem Farbmonitor simuliert wird. Zur Drucksimulation sind sogenannte Drucknachbildungs-Rechner vorhanden, in denen die Farbauszugssignale unter Berücksichtigung der Druckparameter und der Eigenschaften des Farbmonitors derart in Ansteuersignale für den Farbmonitor umgerechnet werden, dass das Schirmbild denselben farblichen Eindruck wie der zu erwartende Mehrfarbendruck auf dem Auflagenpapier vermittelt. Die Drucksimulation auf einem Farbmonitor hat den Nachteil, dass nur ein flüchtiges Kontrollbild entsteht.

In der Druckindustrie besteht aber der Wunsch, materielle, farbige Kontrollbilder, sogenannte Proofs, zur Verfügung zu haben, die dem Auftraggeber zur Beurteilung und zur Freigabe des Druckauftrages zugeschickt werden können.

Damit diese Proofs eine zuverlässige Farbaussage über die zu erwartende Wiedergabequalität des Mehrfarbendruckes liefern, müssen diese farbmetrisch weitestgehend mit dem tatsächlichen Mehrfarbendruck übereinstimmen.

In der internationalen Patentanmeldung PCT/AU 80/00006 (WO 80/02467) wird bereits ein Aufzeichnungsgerät beschrieben, in dem Farbfilme durch farbiges Laserlicht belichtet werden, das von gespeicherten Bilddaten moduliert ist. Dieses bekannte Aufzeichnungsgerät ist aber nicht zur Herstellung von Proofs beim Mehrfarbendruck geeignet, da dort nicht angegeben ist, wie Farbauszugssignale in entsprechende Modulationssignale für das Laserlicht umgewandelt werden müssen, damit Mehrfarbendruck und Proof farbidentisch sind.

In der Zeitschrift Laser + Elektronik-Optik, Nr. 2/1973, wird ein Farbbild-Recorder mit Laserbelichtung zur Aufzeichnung von Fernsehsendungen beschrieben. Auch dieses Gerät ist nicht beim Mehrfarbendruck zu verwenden, da dort NTSC-Farbfernsehsignale in Modulationssignale für das Laserlicht umgewandelt werden.

Der Erfindung liegt daher die Aufgabe zugrunde, ein Verfahren und eine Einrichtung zur Aufzeichnung von Farbbildern beim Mehrfarbendruck anzugeben, mit denen eine weitestgehend farbliche Übereinstimmung zwischen Farbbild und späterem Mehrfarbendruck erreicht wird, so dass eine hochwertige und zuverlässige Aussage über die zu erwartende Wiedergabequalität möglich ist.

Die Erfindung wird im folgenden anhand der Fig. 1-5 näher erläutert.

Es zeigen:

Fig. 1 einen Reproduktions-Ablaufplan;
Fig. 2 eine Schaltungsanordnung eines Proof-Recorders;
Fig. 3 eine grafische Darstellung von Druck-Farbraum und Normfarbwert-Koordinatensystem;
Fig. 4 eine grafische Darstellung von Film-Farbraum und Normfarbwert-Koordinatensystem;
Fig. 5 eine weitere grafische Darstellung zur Interpolation.

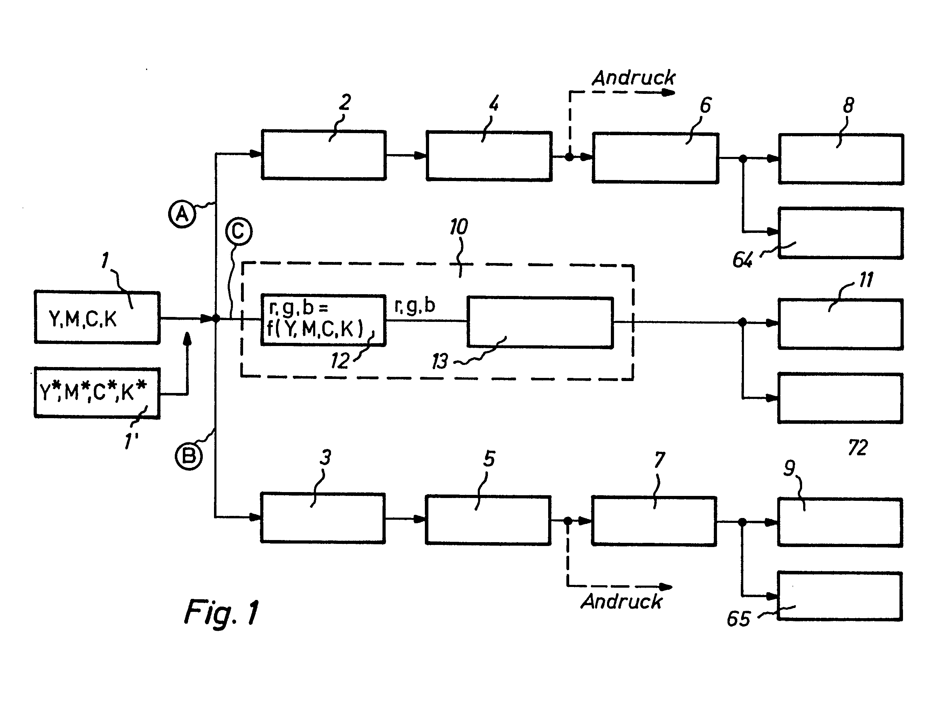

Zur Einführung zeigt Fig. 1 zunächst einen schematischen Reproduktions-Ablaufplan, ausgehend von gespeicherten Farbauszugswerten bis zum fertigen Mehrfarbendruck für das Offsetdruck- und das Tiefdruck-Verfahren.

In einem Speichermedium 1 (Magnetplatte; Magnetband) sind digitale Farbauszugswerte Y, M, C und K der Farbauszüge Gelb (Y), Magenta (M), Cyan (C) und Schwarz (K) eines zu druckenden Bildes bildpunktweise abgelegt. Die Farbauszugswerte sind ein Mass für die erforderlichen Druckfarbmengen bzw. ein Mass für die Näpfchenvolumina im Tiefdruck oder für die Rasterpunkt-Grössen im Offsetdruck.

Die im Speichermedium 1 abgelegten digitalen Farbauszugswerte können sowohl die Farbauszugswerte eines Einzelbildes oder aber einer montierten Druckseite sein. Die Farbauszugswerte der Einzelbilder wurden in einem Farbscanner durch bildpunktweise, trichromatische Abtastung, optoelektronische Wandlung des Abtastlichtes in Farb-messwertsignale, Erzeugen der Farbauszugssi-gnale durch Farbkorrektur aus den Farbmesswert-signalen unter Berücksichtigung der Gesetzmäs-sigkeiten der subtraktiven Farbmischung sowie durch Analog/Digital-Wandlung der Farbauszugssignale gewonnen.

Die Kombination der Einzelbild-Farbauszugswerte zur Datenmenge einer Druckseite nach einem Layout-Plan erfolgte beispielsweise durch eine elektronische Seitenmontage nach der DE-A 2161038 in einer Bildverarbeitungsanlage. Bei Bedarf wurden die Farbauszugswerte in der Bildverarbeitungsanlage zusätzlich durch eine örtlich begrenzte elektronische Retusche z.B. nach der DE-A 2920058 modifiziert, um die Farbkorrektur zu optimieren oder um redaktionelle Änderungen oder Wünsche der Auftraggeber zu berücksichtigen.

Zur Druckform-Herstellung werden die farbkorrigierten und/oder retuschierten und kombinierten Farbauszugswerte aus dem Speichermedium 1 ausgelesen und im Falle des Offsetdrucks (Weg A) einer Schwarz/Weiss-Aufzeichnungseinheit 2 und im Falle des Tiefdrucks (Weg B) einer Graviereinheit 3 zugeführt und dort wieder in analoge Farbauszugssignale umgewandelt.

Mit der Aufzeichnungseinheit 2 werden im Falle des Vierfarbendrucks vier gerasterte Farbauszüge auf Filmmaterial erzeugt, von denen dann die Druckplatten 4 hergestellt werden, oder direkt auf die Druckplatten 4 belichtet. Mit der Graviereinheit 3 erfolgt die Gravur von vier Druckzylindern 5.

Als Aufzeichnungseinheit 2 kann z.B. ein Chromagraph DC 300 und als Graviereinheit 3 ein Klischograph K 200 der Dr.-Ing. Rudolf Hell GmbH verwendet werden. Die Wirkungsweise solcher Geräte sind bekannt und werden ausserdem in der DE-C 2107738 und DE-C 2508734 beschrieben, so dass eine detaillierte Erläuterung entfallen kann.

Die Druckplatten 4 einerseits und die Druckzylinder 5 andererseits sind die Druckformen für die Druckfarben Gelb, Magenta, Cyan und Schwarz, von denen in Auflagendruckmaschinen 6 oder 7 der Mehrfarbendruck 8 (Offsetdruck) oder der Mehrfarbendruck 9 (Tiefdruck) hergestellt werden.

Für eine zeitlich vor der Druckform-Herstellung liegende Qualitäts- und Farbkontrolle des zu erwartenden Druckergebnisses wird ausgehend von den im Speichermedium 1 abgelegten Farbauszugswerten Y, M, C und K mittels eines Proof-Recorders 10 über den Weg C des Reproduktions-Ablaufplanes ein Proof 11 auf einem Farbmaterial, z.B. auf einem Farbfilm, belichtet, der mit dem noch nicht existierenden Mehrfarbendruck 8 oder 9 farbidentisch ist und somit in vorteilhafter Weise eine vorweggenommene, farbverbindliche Prüfung der Druckqualität ermöglicht.

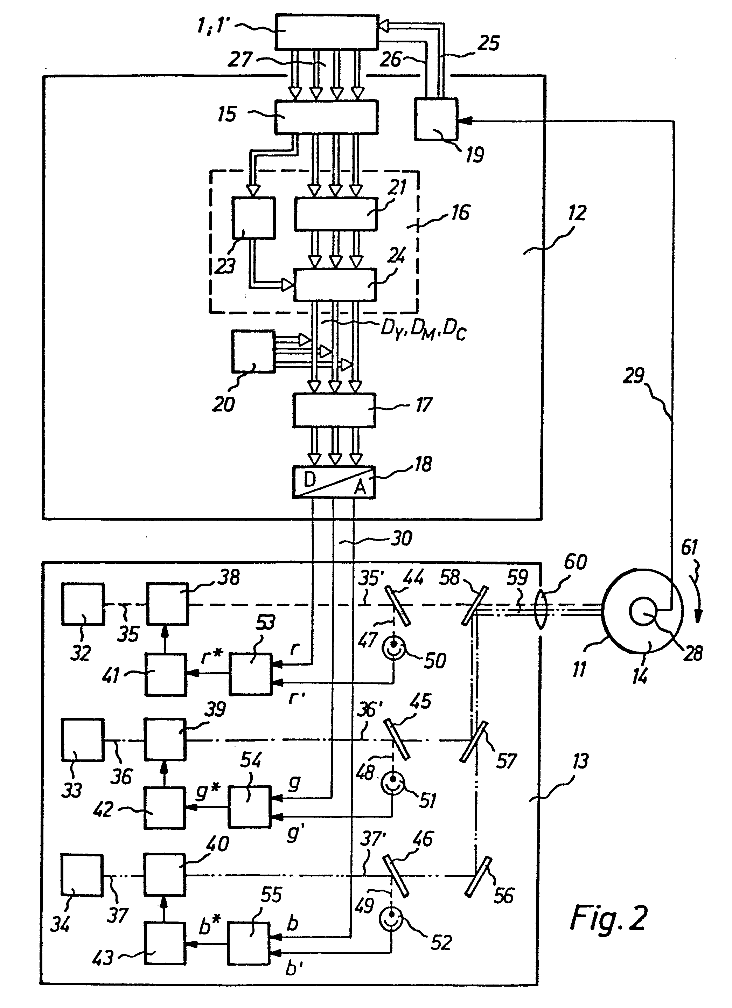

Ein derartiger Proof-Recorder 10, der in Fig. 2 ausführlich dargestellt und beschrieben wird, besteht prinzipiell aus einer Ansteuerschaltung 12 und einer Farb-Aufzeichnungseinheit 13. In der Ansteuerschaltung 12 werden die Farbauszugs-werte Y, M, C und K gemäss Gleichungen (1) in Ansteuerwerte r, g und b für die Farb-Aufzeich-nungseinheit 13 umgeformt.

$$r, g, b = f (Y, M, C, K) \qquad (1)$$

Die Farb-Aufzeichnungseinheit 13 erzeugt einen roten, einen grünen und einen blauen Lichtstrahl, welcher von den zugehörigen Ansteuerwerten r, g und b selektiv intensitätsmoduliert wird.

Die drei intensitätsmodulierten Lichtstrahlen belichten punkt- und zeilenweise den Farbfilm, wobei jeder Lichtstrahl eine der drei Farbschichten des Farbfilms anspricht. Der belichtete und entwickelte Farbfilm ist der gewünschte Proof 11.

Für die Umsetzung der Farbauszugswerte Y, M, C und K in die Ansteuerwerte r, g und b für die Lichtstrahlen gelten folgende Zusammenhänge.

Jedes Quadrupel Farbauszugswerte Y, M, C und K repräsentiert eine auf das Auflagenpapier zu druckende Farbe des Mehrfarbendruckes 8 oder 9, im folgenden Druck-Farbe genannt.

Jede auf dem Farbfilm erzeugte Farbe, im folgenden Film-Farbe genannt, ist durch die in den Farbschichten des Farbfilms erreichten Farbstoff-konzentrationen bzw. Farbdichte-Tripel $D_Y$, $D_M$ und $D_C$ gekennzeichnet.

Für die Herstellung eines mit dem Mehrfarbendruck 8 oder 9 farbidentischen Proof 11 muss daher jedem Quadrupel Farbauszugswerte Y, M, C und K dasjenige Farbdichte-Tripel $D_Y$, $D_M$ und $D_C$ (Soll-Farbdichten) zugeordnet sein, das die mit der entsprechenden Druck-Farbe farbmetrisch übereinstimmende Film-Farbe repräsentiert.

$$D_Y, D_M, D_C = f_1 (Y, M, C, K) \qquad (2)$$

Um die identischen Film-Farben auf dem Farbfilm zu erzeugen, müssen die Soll-Farbdichten $D_Y$, $D_M$ und $D_C$ in entsprechende Ansteuerwerte r, g und b gemäss Gleichung (3) umgesetzt werden.

$$r, g, b = f_2 (D_Y, D_M, D_C) \qquad (3)$$

Die Ansteuerwerte r, g und b ihrerseits bestimmen die auf den Farbschichten des Farbfilms gelangenden Lichtenergien und diese wiederum die Farbstoffkonzentrationen bzw. Farbdichten (Ist-Farbdichten) in den Filmschichten und damit letztlich die Film-Farbe.

Da der Zusammenhang zwischen Ansteuerwerten und Lichtenergien einerseits und zwischen Lichtenergien und erreichten Farbdichten aufgrund der Farbgradation des Farbfilmes andererseits nicht linear ist, muss eine Lichtregelung und eine Farbdichte-Linearisierung ($f_2$=Linearisie-rungsfunktion) durchgeführt werden, damit die Soll-Farbdichten $D_Y$, $D_M$ und $D_C$ auch auf dem Farbfilm erreicht werden. Damit kann für alle weiteren Betrachtungen der Gleichung (2) zugrunde gelegt werden, da jedes Farbdichte-Tripel $D_Y$, $D_M$ und $D_C$ die tatsächlich erzielte Film-Farbe angibt.

Das Verfahren zur Ermittlung der zu den jeweiligen Farbauszugs-Quadrupeln Y, M, C und K gehörenden Farbdichte-Tripel $D_Y$, $D_M$ und $D_C$ gemäss Gleichung (2) ist Gegenstand der vorliegenden Erfindung. Zur Durchführung des Verfahrens sind ausgewählte Farbauszugswerte Y*, M*, C* und K* in einem weiteren Speichermedium 1' abgelegt, auf die später näher eingegangen wird.

Da das Verfahren nur verständlich wird, wenn die Wirkungsweise eines Proof-Recorders bekannt ist, soll vor Erläuterung des Verfahrens noch der Aufbau und die Wirkungsweise des Proof-Recorders anhand der Fig. 2 beschrieben werden.

Fig. 2 zeigt ein detailliertes Ausführungsbeispiel für den Proof-Recorder 10 mit der Ansteuerschaltung 12, der Farb-Aufzeichnungseinheit 13 und einer Aufzeichnungstrommel 14, auf die der zu belichtende Farbfilm 11 (Proof) aufgespannt ist. Selbstverständlich kann auch eine Flachbett-Aufzeichnung durchgeführt werden.

Die Ansteuerschaltung 12 besteht im einzelnen aus einer Gradations-Stufe 15, einem Farbumsetzer 16, einer Linearisierungs-Stufe 17, einem D/A-Wandler 18 sowie aus einem Speichersteuerwerk 19 und einem Farbkeil-Generator 20. Der Farbumsetzer 16 ist im Ausführungsbeispiel aus einer Interpolations-Stufe 21, einem Schwarzwert-Rechner 23 und einer Überlagerungs-Stufe 24 aufgebaut.

Die Wirkungsweise der Ansteuerschaltung 12 ist folgende. Zur Belichtung des Farbfilms 11 ruft das Speichersteuerwerk 19 über einen Adress-Bus 25 die Adressen des Speichermediums 1 bzw. 1' auf, und die Farbauszugswerte Y, M, C und K der einzelnen Bildpunkte werden mit einem Lesetakt auf einer Leitung 26 Zeile für Zeile und innerhalb einer Zeile Bildpunkt für Bildpunkt ausgelesen und über Daten-Busse 27 an die Ansteuerschaltung 12 gegeben. Durch eine Impulsfolge, die in einem mit der Aufzeichnungstrommel 14 gekoppelten Impulsgeber 28 erzeugt wird und über eine Leitung 29 an das Speichersteuerwerk 19 gelangt, ist der Lesetakt und damit der Auslesevorgang aus dem Speichermedium 1 mit der Drehbewegung der Aufzeichnungstrommel 14 synchronisiert. Die Farbauszugswerte Y, M, C und K werden in der Gradations-Stufe 15 nach einer vom Druckprozess abhängigen Druckgradations-Kurve modifiziert, so dass sie der Druckdichte proportional sind. Die Druckgradations-Stufe 15 ist z.B. ein ladbarer Speicher (RAM), in dem die Druckgradations-Kurve abgespeichert ist. Die modifizierten Farbauszugssignale Y, M und C werden der Interpolations-Stufe 21 und die Farbauszugswerte K für den Schwarzauszug dem Schwarzwert-Rechner 23 im Farbumsetzer 16 zugeführt. Die Interpolations-Stufe 21 gibt die gemäss Gleichung (2) zugeordneten Farbdichte-Tripel $D_Y$, $D_M$ und $D_C$ aus. Dabei ist im gewählten Ausführungsbeispiel in vorteilhafter Weise die Zuordnung von Farbauszugswerten und Farbdichten gemäss Gleichung (2) nur für ein Stützpunkt-Netz des Druck-Farbraumes berechnet worden und in einem internen Stützwert-Speicher der Interpolations-Stufe 21 abgelegt, während die bei der Aufzeichnung des Proofs benötigten Zuordnungen durch Interpolation ermittelt werden. Alternativ kann die Zuordnung auch unabhängig von dem tatsächlichen Datenbestand des Speichermediums 1 bzw. von den zu druckenden Farben für alle theoretisch möglichen Farben des Druck-Farbraumes vor der Aufzeichnung des Proofs berechnet werden. In diesem Falle wird die Interpolations-Stufe 21 durch einen entsprechend grösseren Zuordnungs-Speicher ersetzt. Der Schwarzwert-Rechner 23 errechnet aus den Farbauszugswerten K Schwarzwerte, die den Farbdichte-Tripeln in der Überlagerungs-Stufe 24 korrigierend hinzugefügt werden. Die Berechnung der Schwarzwerte kann auch bereits vor der Aufzeichnung des Proofs erfolgen und mit in den Datenbestand des Stützwert-Speichers bzw. des Zuordnungs-Speichers aufgenommen sein.

Die aus dem Farbumsetzer 16 ausgegebenen Farbdichtewerte $D_Y$, $D_M$ und $D_C$ werden in der Linearisierungs-Stufe 17 in Abhängigkeit von $\gamma$-Werten bzw. der Gradations-Kurven der Farbschichten des verwendeten Farbfilms linearisiert und in die digitalen Ansteuerwerte umgesetzt. Die digitalen Ansteuerwerte werden dann im nachgeschalteten D/A-Wandler 18 in analoge Ansteuerwerte r, g und b umgewandelt und der Farb-Aufzeichnungseinheit 13 über Leitungen 30 zugeführt. Die Linearisierungs-Stufe 17 ist ebenfalls ein ladbarer Speicher (RAM), in dem die durch die Linearisierung ermittelten digitalen Ansteuerwerte r, g und b abgelegt sind und von den entsprechenden Farbdichtewerten $D_Y$, $D_M$ und $D_C$ aufgerufen werden.

Die Farb-Aufzeichnungseinheit 13 besteht im Ausführungsbeispiel aus drei Lasern 32, 33 und 34, welche monochromatisches Laserlicht aus dem roten, dem grünen und dem blauen Spektralbereich erzeugen. Der Laser 32 ist z.B. ein HeNe-Laser mit der Wellenlänge 633 nm (Rot). Die Laser 33 und 34 sind beispielsweise Ar-Laser mit der Wellenlänge 514 nm (Grün) bzw. 476 nm (Blau). Alternativ könnte ein Multiline-Laser Verwendung finden, der schmalbandiges Laserlicht aus allen drei Spektralbereichen erzeugt. Der rote, grüne und blaue Laserstrahl 35, 36 und 37 wird in Lichtmodulatoren 38, 39 und 40 intensitätsmoduliert. Die Lichtmodulatoren 38, 39 und 40 werden über Steuerverstärker 41, 42 und 43 in Abhängigkeit der in der Ansteuerschaltung 12 erzeugten Ansteuerwerte r, g und b gesteuert. Die Ansteuerwerte sind gleichzeitig die Sollwerte für eine Lichtregelung, durch die ein linearer Zusammenhang zwischen Ansteuerwerten und Lichtintensitäten hergestellt wird. Zur Istwert-Erfassung der Lichtintensitäten werden aus den Laser-Strahlen 35', 36' und 37' mit teildurchlässigen Spiegeln 44, 45 und 46 Teilstrahlen 47, 48 und 49 ausgespiegelt und deren Intensitäten mittels Fotodioden 50, 51 und 52 als Istwert-Signale r', g' und b' gemessen. Durch Vergleich von Istwert-Signalen r', g' und b' und Ansteuersignalen r, g und b werden in Vergleichern 53, 54 und 55 Regelsignale r*, g* und b*

gebildet, die den Steuerverstärkern 41, 42 und 43 zugeführt werden. Die Lichtmodulatoren 38, 39 und 40 sind beispielsweise akustooptische Modulatoren (AOM).

Die modulierten Laserstrahlen 35', 36' und 37' werden mit Hilfe eines Spiegels 56 und zweier dichroitischer Farbfilter 57 und 58 in einem Aufzeichnungsstrahl 59 vereinigt. Der Aufzeichnungsstrahl 59 wird mit einem Objektiv 60 auf den Farbfilm 11 fokussiert und nimmt aufgrund der Drehbewegung der Aufzeichnungstrommel 14 in Richtung eines Pfeiles 61 und durch eine axiale Relativbewegung zwischen dem Aufzeichnungsstrahl 59 und der Aufzeichnungstrommel 14 die punkt- und zeilenweise Belichtung des Farbfilmes 11 vor.

Der Farbfilm 11 kann ein Negativ-Farbfilm oder ein Positiv-Farbfilm (Umkehrfilm) sein. Den weiteren Ausführungen liegt ein Negativ-Farbfilm zugrunde. Ein solcher Negativ-Farbfilm besteht bekanntlich aus einer für den roten Spektralbereich sensibilisierten Cyan-Farbschicht, einer für den grünen Spektralbereich sensibilisierten Magenta-Farbschicht und aus einer für den blauen Spektralbereich sensibilisierten Gelb-Farbschicht. Durch selektives Belichten des Farbfilms 11 mit dem roten Laserstrahl 35' wird daher die Primärfarbe Cyan, durch Belichten mit dem grünen Laserstrahl 36' die Primärfarbe Magenta und durch Belichten mit dem blauen Laserstrahl 37' die Primärfarbe Gelb erzeugt. Durch gleichzeitige Belichtung des Farbfilms mit allen drei Laserstrahlen entstehen dann durch subtraktive Mischung der Primärfarben alle übrigen Farben.

Zur Farbdichte-Linearisierung, deren Notwendigkeit bereits erläutert wurde, werden zunächst für jede Farbschicht des Farbfilms Farbkeile, d.h. gestufte Farbdichten auf das Filmmaterial belichtet. Im Ausführungsbeispiel erzeugt der Farbkeil-Generator 20 in zeitlicher Folge gestufte Farbdichtewerte, die in der Linearisierungs-Stufe 17 in entsprechende Ansteuerwerte r, g und b umgewandelt werden, wobei die Linearisierungs-Stufe 17 zunächst linear wirkt. Alternativ könnte der Proof-Recorder 10 zur Aufzeichnung des Farbkeiles auch mit den im Speichermedium 1' abgelegten Farbauszugswerten Y*, M*, C* und K* angesteuert werden, wozu die Linearisierungs-Stufe 17 bereits mit der Umkehrfunktion sowie mit den maximalen Werten geladen und die Interpolations-Stufe 21 linear wirkend ist.

Nachdem die drei Farbkeile aufbelichtet sind, werden die Farbdichten mit dem Densitometer oder über den Remissionsgrad $\beta(\lambda)$ mit dem Spektralfotometer bei einer bestimmten Wellenlänge $\lambda$ nach der Beziehung $d = \log. 1/\beta(\lambda)$ gemessen und den gemessenen Dichtewerten diejenigen Ansteuerwerte funktionsmässig zugeordnet, mit denen die Dichtewerte entstanden sind. Die Umkehrfunktion stellt die Farbgradations-Kurve dar, aus der die korrigierten für den linearen Zusammenhang erforderlichen Ansteuerwerte ermittelt und in der Linearisierungs-Stufe 17 abgelegt werden.

Gleichzeitig mit der Farbdichte-Linearisierung werden noch die zu den in den Farbschichten maximal erreichbaren Farbdichten gehörigen Ansteuerwerte $r_{max}$, $g_{max}$ und $b_{max}$ bzw. die zugehörigen Soll-Farbdichten $D_{Ymax}$, $D_{Mmax}$ und $D_{Cmax}$ ermittelt, welche zur späteren Verwendung in dem Farbkeil-Generator 20 abrufbar gespeichert werden.

Dabei wird unter maximaler Farbdichte einer Filmschicht derjenige Dichtewert verstanden, der in dieser Filmschicht erreicht werden kann, ohne dass die anderen Filmschichten über den Schleier hinweggehen.

Nachdem nun der zum Verständnis des erfindungsgemässen Verfahrens erforderliche Reproduktions-Ablaufplan sowie die Wirkungsweise des Proof-Recorders einschliesslich der Farbdichte-Linearisierung bekannt sind, wird das Verfahren zur Bestimmung der Soll-Farbdichten selbst beschrieben, die zur farbäquivalenten Wiedergabe von Druck-Farben auf Filmmaterial erforderlich sind.

Das Verfahren besteht im einzelnen aus den Verfahrensschritten a) bis e).

Im Verfahrensschritt a) werden einige charakteristische Druck-Farben des Druck-Farbraumes gewählt und in Form von Farbfeldern unter Fortdruckbedingungen, d.h. unter realen, beim späteren Auflagendruck herrschenden Bedingungen, gedruckt.

Unter realen Bedingungen wird der Druck auf Auflagenpapier mit echten Druckfarben sowie mit der Papier-Laufgeschwindigkeit und der Maschineneinstellung der Auflagen-Druckmaschinen verstanden.

Die zu jeder gewählten Druck-Farbe gehörenden Farbauszugswerte Y*, M*, C* und K* werden beispielsweise von dem Speichermedium 1' abgerufen, der im Reproduktions-Ablaufplan der Fig. 1 dargestellt ist, und zum Druck der Farbfelder auf dem Auflagenpapier, im folgenden Druck-Farbfelder 64 bzw. 65 genannt, je nach dem benutzten Druckverfahren auf dem Weg A oder B verarbeitet.

Der Druck der Farbfelder kann entfallen, wenn bereits eine mit denselben Druckparametern entstandene Farbskala, auch Farbatlas oder Farbtafel genannt, vorhanden ist. In diesem Falle werden die charakteristischen Farbfelder aus den gedruckten Farben der Farbskala ausgewählt.

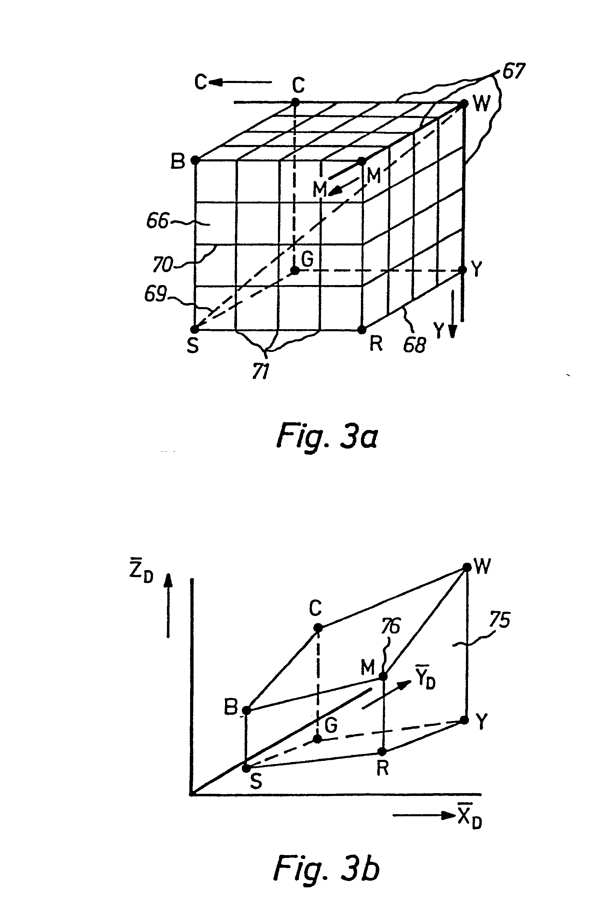

Zur Auswahl der charakteristischen Druck-Farben zeigt Fig. 3a einen idealisierten, würfelförmigen Druck-Farbraum 66, der durch die Y-, M-, C-Farbkoordinatenachsen 67 aufgespannt wird und in dem jede Druck-Farbe bzw. jeder Druck-Farbort durch ein Farbkoordinaten-Tripel (Y; M; C) definiert ist. Als charakteristische Druck-Farben werden zweckmässigerweise die Eckfarben, nämlich die Primärfarben Gelb (Y*), Magenta (M*) und Cyan (C*), die Sekundärfarben Rot (Y*; M*), Grün (Y*; C*) und Blau (M*; C*), ausserdem Weiss und Schwarz (Y*; M*; C*), sowie einige auf den Würfelkanten 68 und der Grauachse 69 liegende Zwischenfarben gewählt. Gleichzeitig ist ein sich über den Druck-Farbraum 66 erstreckendes Stützpunkt-Netz 70 mit drei Stützpunkten 71 auf jeder Würfelkante 68 angedeutet.

Die Zwischenfarben werden zweckmässigerweise so gewählt, dass sie mit Stützpunkten 71, in Fig. 3a jeweils mit dem mittleren Stützpunkt, übereinstimmen. Selbstverständlich ist die Anzahl der Stützpunkte im praktischen Ausführungsbeispiel wesentlich grösser.

In einem Verfahrensschritt b) werden mit Hilfe des Proof-Recorders 10 charakteristische Film-Farben des Filmraumes, unter denen alle Eckfarben sein sollten, mit maximaler Farbdichte in Form von Farbfeldern, im folgenden mit Film-Farbfeldern 72 bezeichnet, auf dem für den Proof vorgesehenen Filmmaterial belichtet, wozu wiederum ausgewählte Farbauszugswerte Y*, M*, C* und K* aus dem Speichermedium 1' ausgelesen und dem Proof-Recorder 10 zugeführt werden (Fig. 1 und 2).

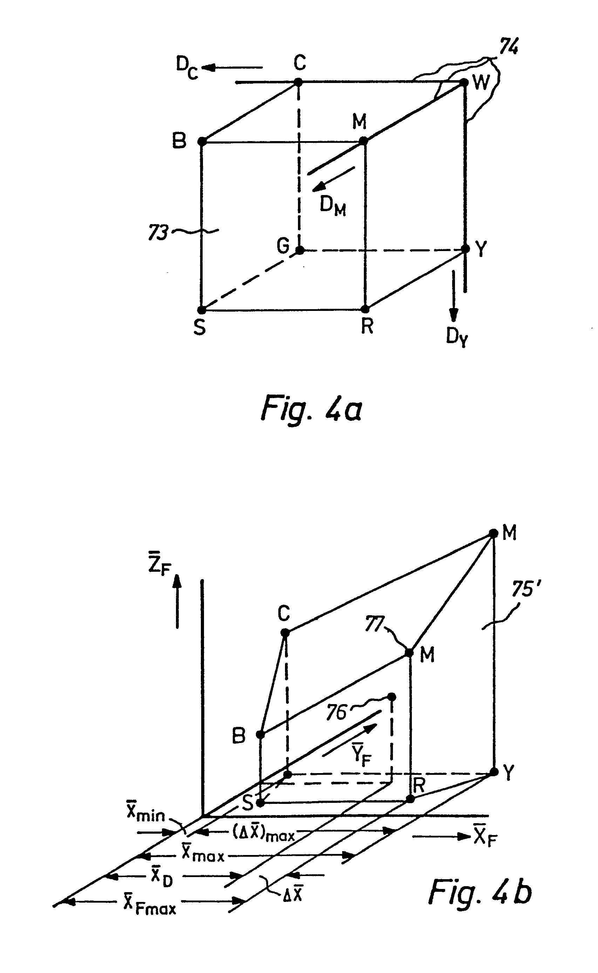

Fig. 4 zeigt einen solchen Film-Farbraum 73, der von den Farbdichte-Koordinatenachsen 74 ($D_Y$, $D_M$ und $D_C$) aufgespannt wird und in dem jede Film-Farbe bzw. Film-Farbart durch ein Farbdichte-Tripel ($D_Y$; $D_M$; $D_C$) definiert ist.

Als charakteristische Film-Farben werden zunächst die Eckfarben des Film-Farbraumes 73 Gelb ($D_{Ymax}$) Magenta ($D_{Mmax}$) und Cyan ($D_{Cmax}$) sowie Schwarz ($D_{Ymax}$; $D_{Mmax}$; $D_{Cmax}$), Weiss, Rot ($D_{Ymax}$; $D_{Mmax}$), Grün ($D_{Ymax}$; $D_{Cmax}$) und Blau ($D_{Mmax}$; $D_{Cmax}$) gewählt.

Die zur Belichtung der charakteristischen Film-Farben mit maximaler Farbdichte benötigten Farbdichtewerte $D_{Ymax}$, $D_{Mmax}$ und $D_{Cmax}$ werden im Ausführungsbeispiel vom Farbkeil-Generator 20 (Fig. 2) ausgegeben, in der Linearisierungs-Stufe 17 in entsprechende Ansteuerwerte $r_{max}$, $g_{max}$ und $b_{max}$ umgeformt und der Farb-Aufzeichnungseinheit 13 des Proof-Recorders 10 zugeführt.

Die zur Belichtung der einzelnen Film-Farben benötigten Ansteuerwerte sind in nachfolgender Tabelle angegeben.

| Film-Farbe | Farbdichten | Ansteuerwerte |
|---|---|---|
| Gelb | $D_{Ymax}$ | $b_{max}$ |
| Magenta | $D_{Mmax}$ | $g_{max}$ |
| Cyan | $D_{Cmax}$ | $r_{max}$ |
| Weiss | | |
| Schwarz | $D_{Ymax}$; $D_{Mmax}$; $D_{Cmax}$ | $r_{max}$; $g_{max}$; $b_{max}$ |
| Rot | $D_{Ymax}$; $D_{Mmax}$ | $g_{max}$; $b_{max}$ |
| Grün | $D_{Ymax}$; $D_{Cmax}$ | $r_{max}$; $b_{max}$ |
| Blau | $D_{Mmax}$; $D_{Cmax}$ | $r_{max}$; $g_{max}$ |

In einem Verfahrensschritt c) werden für jede mit Soll-Farbdichte erzeugte Druck-Farbe des Druck-Farbraumes Farbkennzeichnungswerte, z.B. die Normfarbwerte $\overline{X}_D$, $\overline{Y}_D$ und $\overline{Z}_D$ und für jede mit maximaler Farbdichte belichtete Film-Farbe, welche im wesentlichen die Eckfarben des Film-Farbraumes sind, die entsprechenden Normfarbwerte $\overline{X}_{Fmax}$, $\overline{Y}_{Fmax}$ und $\overline{Z}_{Fmax}$ bestimmt.

Die Ermittlung der Normfarbwerte gemäss Verfahrensschritt c) erfolgt z.B. über die Spektralverläufe der einzelnen Farben. Dazu werden die Spektralverläufe, d.h. der Zusammenhang zwischen dem Remissionsgrad β der Farben und der Wellenlänge im Bereich des sichtbaren Lichtes zwischen λ=400 bis 700 nm beispielsweise nach dem Spektralverfahren oder dem Drei-Bereichsverfahren nach DIN 5030 ausgemessen.

Beim Spektralverfahren wird zunächst die Farbreizfunktion nach Gleichung (4) ermittelt.

$$\vartheta(\lambda) = S(\lambda) \cdot \beta(\lambda) \qquad (4)$$

In Gleichung (4) ist $\beta(\lambda)$ der zu messende Remissionsgrad und $S(\lambda)$ die bekannte Spektralfunktion einer Normlichtquelle, mit der die auszumessenden Druck-Farbfelder 66 und Film-Farbfelder beleuchtet werden. Die Lichtart der Normlichtquelle sollte der Betrachtungslichtart entsprechen, die auch zur Beurteilung des Auflagendrucks verwendet wird. Durch Messen des von den Druck-Farben und Film-Farben reflektierten Lichtes mittels eines Spektralfotometers wird der Remissionsgrad $\beta(\lambda)$ und somit bei bekannter Spektralfunktion $S(\lambda)$ auch gleichzeitig die Farbreizfunktion $\vartheta(\lambda)$ gemäss Gleichung (4) gemessen.

Die Normfarbwerte $\overline{X}$, $\overline{Y}$ und $\overline{Z}$ ergeben sich dann nach DIN 5033 aus folgenden Gleichungen (5).

$$\overline{X} = k \int \vartheta(\lambda)\, \overline{x}\, d\lambda$$
$$\overline{Y} = k \int \vartheta(\lambda)\, \overline{y}\, d\lambda \qquad (5)$$
$$\overline{Z} = k \int \vartheta(\lambda)\, \overline{z}\, d\lambda$$

In den Gleichungen (5) sind $\overline{x}$, $\overline{y}$ und $\overline{z}$ Normspektralwerte, welche die physiologische Farbempfindung eines Normalbetrachters wiedergeben.

Falls die Eckfarben Rot, Grün und Blau des Film-Farbraumes nicht im Verfahrensschritt b) belichtet wurden, lassen sich deren Spektralverläufe auch aus den Spektralverläufen der drei Filmschichten bestimmen.

Nach Verfahrensschritt c) sind die Normfarbwerte $\overline{X}_D$, $\overline{Y}_D$ und $\overline{Z}_D$ der charakteristischen Druck-Farben und die Normfarbwert-Tripel $\overline{X}_{Fmax}$, $\overline{Y}_{Fmax}$ und $\overline{Z}_{Fmax}$ der charakteristischen Film-Eckfarben bekannt.

Fig. 3b zeigt dazu das Norm-Farbkoordinatensystem 75, in dem jede Druck-Farbe durch ein Normfarbwert-Tripel, z.B. die Druck-Eckfarbe 76 Magenta durch das Normfarbwert-Tripel ($\overline{X}_D$; $\overline{Y}_D$; $\overline{Z}_D$), beschrieben ist.

Ein entsprechendes Normfarbwert-Koordinatensystem 75' ist in Fig. 4b für den Film-Farbraum 73 dargestellt. In diesem Normfarbwert-Koordinatensystem 75' wird jede Film-Farbe durch ein Normfarbwert-Tripel ($\overline{X}_F$; $\overline{Y}_F$; $\overline{Z}_F$) und jede Film-Eckfarbe, z.B. Magenta durch das Normfarbwert-Tripel ($\overline{X}_{Fmax}$; $\overline{Y}_{Fmax}$; $\overline{Z}_{Fmax}$) beschrieben. In den Normfarbwert-Koordinatensystemen verläuft die X-Achse verabredungsgemäss in Richtung steigenden Rotanteils, die Y-Achse in Richtung steigenden Grünanteils und die Z-Achse in Richtung steigenden Blauanteils.

Ein Vergleich der Fig. 3b und 4b zeigt, dass die Farbräume 66 bzw. 73 in den beiden Normfarbwert-Koordinatensystemen 75 bzw. 75' unterschiedliche Gestalt haben. Mit anderen Worten werden die charakteristischen Druck-Farben und Film-Farben durch unterschiedliche Normfarbwerte wiedergegeben, was am Beispiel der Farbe Magenta erläutert wird. Wird der Druck-Farbort 76 Magenta in das Normfarbwert-Koordinatensystem 75' projiziert, so fällt dieser nicht mit dem Film-Farbort 77 Magenta zusammen, Druck- und Film-Farbe Magenta sind also nicht farbäquivalent, da $\overline{X}_D \neq \overline{X}_{Fmax}$, $\overline{Y}_D \neq \overline{Y}_{Fmax}$ und $\overline{Z}_D \neq \overline{Z}_{Fmax}$ sind. Ein Verfahrensschritt d) besteht darin, die maximalen Farbdichten $D_{Ymax}$, $D_{Mmax}$ und $D_{Cmax}$, mit denen die charakteristischen Film-Farben im Verfahrensschritt a) belichtet wurden, derart in Soll-Farbdichtewerte $D_Y$, $D_M$ und $D_C$ bzw. Soll-Ansteuerwerte r, g und b abzuändern, dass die mit den Soll-Farbdichten belichteten Film-Farben dieselben oder nahezu dieselben Normfarbwerte wie die entsprechenden Druck-Farben aufweisen ($\overline{X}_F \approx \overline{X}_D$; $\overline{Y}_F \approx \overline{Y}_D$; $\overline{Z}_F \approx \overline{Z}_D$), wodurch die farbäquivalente Wiedergabe der Druck-Farben auf dem Filmmaterial sichergestellt wird.

Die Abänderung der maximalen Farbdichtewerte in die erforderlichen Soll-Farbdichtewerte kann nur durch eine iterative Näherung erfolgen, da sich bereits bei Änderung nur eines maximalen Dichtewertes alle drei Normfarbwerte ändern.

Zur Ermittlung der Soll-Farbdichtewerte können verschiedene Näherungsverfahren angewendet werden, z.B. das von N. Ohta, das in der Zeitschrift «Applied Optics», Sept. 71, vol. 10, Nr. 9, beschrieben ist.

Im Ausführungsbeispiel wird ein vereinfachtes Näherungsverfahren angegeben, von dem ein Zyklus für eine der Druck-Farben, z.B. für die Druck-Farbe 76 Magenta, in den Schritten $d_1$) bis $d_4$) wie folgt abläuft.

In einem ersten Schritt $d_1$) werden zunächst, z.B. nach der Abstandsformel (6), die vektoriellen Abstände d zwischen dem betreffenden Druck-Farbort (76) und allen Film-Eckfarborten im Normfarbwert-Koordinatensystem (75') des Film-Farbraumes (73) berechnet und der dem betreffenden Druck-Farbort (76) am nächsten liegende Film-Farbort festgestellt.

$$d = \sqrt{(X_{Fmax} - X_D)^2 + (Y_{Fmax} - Y_D)^2 + (Z_{Fmax} - Z_D)^2} \quad (6)$$

In einem zweiten Schritt $d_2$) werden nach Gleichungen (7) die Normfarbwert-Differenzen zwischen dem Druck-Farbort (76) und dem am nächsten liegenden Film-Farbort gebildet und die maximale Normfarbwert-Differenz markiert, also die grösste koordinatenmässige Abweichung der beiden Farborte.

$$\begin{aligned} \Delta\overline{X} &= \overline{X}_{Fmax} - \overline{X}_D \\ \Delta\overline{Y} &= \overline{Y}_{Fmax} - \overline{Y}_D \\ \Delta\overline{Z} &= \overline{Z}_{Fmax} - \overline{Z}_D \end{aligned} \quad (7)$$

In einem dritten Schritt $d_3$) wird dann einer der Farbdichtewerte $D_Y$, $D_M$ oder $D_C$ bzw. einer der Ansteuerwerte r, g oder b um solche Beträge $\Delta D_Y$, $\Delta D_M$ oder $\Delta D_C$ abgeändert, so dass die maximale Normfarbwert-Differenz zu Null wird.

Dabei gilt die Überlegung, dass z.B. mit ansteigendem Ansteuerwert r die Farbstoff-Konzentration der Cyan-Filmschicht bzw. die Cyan-Farbdichte $D_C$ erhöht wird, wodurch insbesondere der Rotanteil des Farbfilms und damit der Normfarbwert $\overline{X}$ am stärksten abnimmt, wobei bei $D_{Cmax}$ der

Normfarbwert $\overline{X}$ minimal ($\overline{X}_{min}$) und bei $D_{Cmin}$ maximal ($\overline{X}_{max}$) ist. Analog sinkt mit steigendem Ansteuerwert g der Normfarbwert $\overline{Y}$ und mit steigendem Ansteuerwert b der Normfarbwert $\overline{Z}$ am stärksten. Die zur Kompensation der Normfarbwert-Differenzen $\Delta\overline{X}$, $\Delta\overline{Y}$ oder $\Delta\overline{Z}$ erforderlichen Änderungsbeträge $\Delta D_C$, $\Delta D_M$ oder $\Delta D_Y$ ergeben sich nach Gleichungen (8).

$$\Delta D_C = \Delta\overline{X} \frac{(\Delta D_C)_{max}}{(\Delta\overline{X})_{max}}$$

$$\Delta D_M = \Delta\overline{Y} \frac{(\Delta D_M)_{max}}{(\Delta\overline{Y})_{max}} \quad (8)$$

$$\Delta D_Y = \Delta\overline{Z} \frac{(\Delta D_Y)_{max}}{(\Delta\overline{Z})_{max}}$$

In den Gleichungen (8) ist:

$$(\Delta\overline{X})_{max} = \overline{X}_{max} - \overline{X}_{min}$$

$$(\Delta\overline{Y})_{max} = \overline{Y}_{max} - \overline{Y}_{min}$$

$$(\Delta\overline{Z})_{max} = \overline{Z}_{max} - \overline{Z}_{min}$$

$$(\Delta D_C)_{max} = D_{Cmax} - D_{Cmin}$$

$$(\Delta D_M)_{max} = D_{Mmax} - D_{Mmin}$$

$$(\Delta D_Y)_{max} = D_{Ymax} - D_{Ymin}$$

In einem Verfahrensschritt $d_4$) werden dann die Normfarbwerte $\overline{X}_{F'}$, $\overline{Y}_{F'}$ und $\overline{Z}_{F'}$ des an den Druck-Farbort angenäherten neuen Film-Farbortes über die Spektralverläufe berechnet. In einem folgenden Zyklus werden wiederum die Normfarbwert-Differenzen zwischen dem Druck-Farbort und dem neuen Film-Farbort bestimmt, die neue maximale Normfarbwert-Differenz festgestellt und die zugehörigen Ansteuerwerte entsprechend geändert, so dass sich wieder ein neuer, weiter angenäherter Film-Farbort ergibt. Diese Näherungszyklen werden nunmehr so lange fortgesetzt, bis der Film-Farbort dem betreffenden Druck-Farbort so nahe gekommen ist, dass sie farbmetrisch nahezu identisch sind.

Nach der Näherungsrechnung gemäss Verfahrensschritt d) ist jeder ausgewählten Druck-Farbe des Druck-Farbraumes bzw. deren Farbauszugswerten Y, M, C und K ein Farbdichte-Tripel $D_Y$, $D_M$ und $D_C$ zugeordnet.

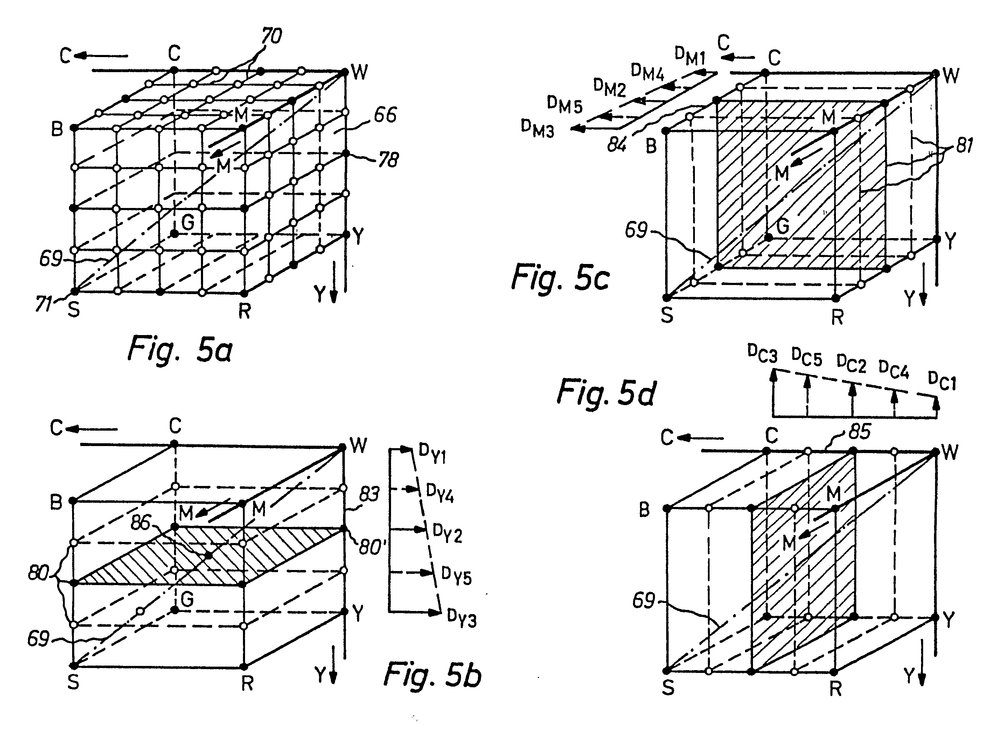

Dazu zeigt Fig. 5a noch einmal den Druck-Farbraum 66 mit dem Stützpunkt-Netz 70 und der Grauachse 69. Die in den vorangegangenen Verfahrensschritten mit Farbdichtewerten belegten Stützpunkte 71 sind als volle Punkte dargestellt, beispielsweise ist der Eckfarbe Weiss das Farbdichte-Tripel $D_{Y1}$, $D_{M1}$ und $D_{C1}$, der Zwischenfarbe 78 das Farbdichte-Tripel $D_{Y2}$, $D_{M2}$ und $D_{C2}$ und der Eckfarbe Gelb das Farbdichte-Tripel $D_{Y3}$, $D_{M3}$ und $D_{C3}$ zugeordnet.

In einem weiteren Verfahrensschritt e) müssen nun allen Stützpunkten 71 des gesamten räumlichen Stützpunkt-Netzes 70, ausgehend von den bereits belegten Stützpunkten, durch eine räumliche Interpolation entsprechende Farbdichte-Tripel zugeordnet werden. Diese noch zu belegenden Stützpunkte sind in Fig. 5a durch offene Punkte dargestellt. Man erkennt, dass die räumliche Interpolation von Werten ausgeht, die im wesentlichen auf den Würfelkanten des Druck-Farbraumes 66 liegen.

Verfahrensschritt e) kann nach einer beliebigen Interpolations-Methode durchgeführt werden. Im Ausführungsbeispiel wird eine besonders vorteilhafte Interpolations-Methode angegeben.

In einem ersten Schritt $e_1$) wird der Druck-Farbraum 66 jeweils für die Farbdichten $D_Y$, $D_M$ und $D_C$ gesondert in einen sogenannten Gelb-Würfel (Fig. 5b), einen Magenta-Würfel (Fig. 5c) und einen Cyan-Würfel (Fig. 5d) unterteilt.

Der Gelb-Würfel ist dadurch gekennzeichnet, dass für alle Stützpunkte, die auf den vier parallel zur Y-Achse verlaufenden Würfelkanten (Weiss-Gelb; Magenta-Rot; Blau-Schwarz; Cyan-Grün), im folgenden Vorzugskanten des Gelb-Würfels genannt, liegen, sich im wesentlichen nur die Farbdichtewerte $D_Y$ ändern, während die Farbdichtewerte $D_M$ und $D_C$ nahezu konstant sind. Ferner sind in allen parallelen Stützpunkt-Ebenen 80 (Gelb-Ebenen), für die die Y-Achse Flächennormale ist, die Farbdichtewerte $D_Y$ in erster Näherung konstant.

Beim Magenta-Würfel dagegen ändern sich bei allen Stützpunkten, die auf den Vorzugskanten (Weiss-Magenta; Cyan-Blau; Gelb-Rot; Grün-Schwarz) liegen, im wesentlichen nur die Farbdichtewerte $D_M$, während in allen parallelen Stützpunkt-Ebenen 81 (Magenta-Ebenen), für die die Magenta-Koordinatenachse Flächennormale ist, die Farbdichtewerte $D_M$ in erster Näherung konstant sind. Schliesslich ändern sich beim Cyan-Würfel für alle auf den Vorzugskanten (Weiss-Cyan; Magenta-Blau; Gelb-Grün; Rot-Schwarz) liegenden Stützpunkte im wesentlichen nur die Farbdichtewerte $C_Y$, während sie für alle auf den parallelen Stützpunkt-Ebenen 82 (Cyan-Ebenen), für die die C-Achse Flächennormale ist, liegenden Stützpunkte im wesentlichen konstant sind.

In einem zweiten Schritt $e_2$) werden für den Gelb-Magenta- und Cyan-Würfel jeweils die auf den vier Vorzugskanten liegenden Stützpunkte durch eine erste Interpolation, im folgenden Kanten-Interpolation genannt, ermittelt.

Die Kanten-Interpolation ist in den Fig. 5b bis 5d jeweils für eine Vorzugskante 83, 84 und 85 anhand von separaten Diagrammen dargestellt, in denen die jeweiligen Farbdichtewerte als Pfeile eingetragen sind. Beim Gelb-Würfel sind beispielsweise die Farbdichten $D_{Y1}$, $D_{Y2}$ und $D_{Y3}$ bekannt, und die Farbdichten $D_{Y4}$ und $D_{Y5}$ (als gestrichelte Pfeile angedeutet) werden durch Interpolation berechnet. Gleichzeitig werden noch die Farbdichtewerte für alle Durchstosspunkte der Graugeraden durch die einzelnen Ebenen ermittelt.

Nach der Kanten-Interpolation und der Interpolation auf der Graugeraden wird in einem Schritt $e_2$) in allen Stützpunkt-Ebenen 80, 81 und 82 einschliesslich der zugehörigen äusseren Würfelflächen des Gelb-, Magenta- und Cyan-Würfels eine zweite Interpolation (Ebenen-Interpolation) durchgeführt, beispielsweise an der Stützpunkt-Ebene 80' des Gelb-Würfels, welche den Durchstosspunkt 86 der Graugeraden 69 aufweist.

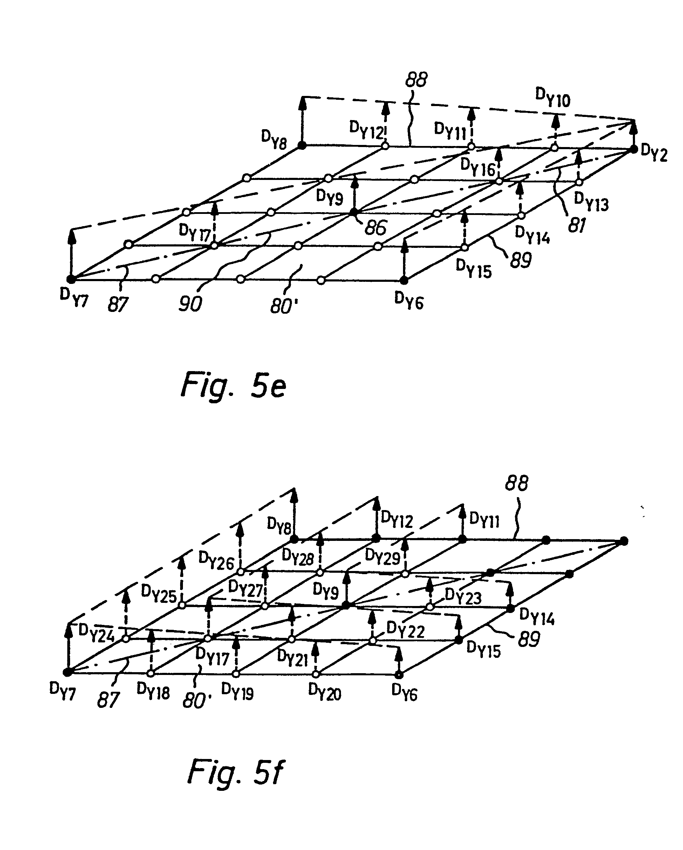

Die Ebenen-Interpolation, die anhand der Fig. 5e und Fig. 5f erläutert wird, läuft in zwei aufeinanderfolgenden Unterschritten $e_{21}$) und $e_{22}$) ab.

Fig. 5e zeigt diese Stützpunkt-Ebene 80', deren Eck-Stützpunkten bereits durch die vorangegangene Kanten-Interpolation die Farbdichtewerte $D_{Y2}$, $D_{Y6}$, $D_{Y7}$ und $D_{Y8}$ zugeordnet wurden. Ferner ist eine Flächendiagonale 87 und der Durchstosspunkt 86 der Graugeraden 69 durch die Stützpunkt-Ebene 80' angedeutet. Da der Durchstosspunkt 86 ein Stützpunkt der Graugeraden 69 ist, wurde der zugehörige Farbdichtewert $D_{Y9}$ bereits bei der Graugeraden-Interpolation festgestellt. Die bereits mit Farbdichtewerten belegten Stützpunkte sind wiederum als volle Punkte, die mit Farbdichtewerten zu belegenden Stützpunkte als offene Punkte und die Farbdichtewerte selbst als Pfeile symbolisiert.

Beim ersten Unterschritt $e_{21}$) der Ebenen-Interpolation werden zunächst auf der Seite 88 der Stützpunkt-Ebene 80' die Farbdichtewerte $D_{Y10}$, $D_{Y11}$ und $D_{Y12}$ zwischen den Farbdichtewerten $D_{Y2}$ und $D_{Y8}$ und auf der Seite 89 die Farbdichtewerte $D_{Y13}$, $D_{Y14}$ und $D_{Y15}$ zwischen den Farbdichtewerten $D_{Y2}$ und $D_{Y6}$ interpoliert und dann auf den durch den Durchstosspunkt 86 festgelegten Abschnitten 90 und 91 der Flächendiagonalen 87 der Farbdichtewert $D_{Y16}$ zwischen den Farbdichtewerten $D_{Y2}$ und $D_{Y9}$ bzw. der Farbdichtewert $D_{Y17}$ zwischen den Farbdichtewerten $D_{Y7}$ und $D_{Y9}$.

Der zweite Unterschritt $e_{22}$) der Ebenen-Interpolation ist in Fig. 5f dargestellt. Zunächst werden parallel zur Seite 88 der Stützpunkt-Ebene 80' alle Farbdichtewerte zwischen den Farbdichtewerten der Seite 89 und den Farbdichtewerten der Flächendiagonalen 87 interpoliert, im einzelnen die Farbdichtewerte $D_{Y18}$, $D_{Y19}$ und $D_{Y20}$ zwischen den Farbdichtewerten $D_{Y7}$ und $D_{Y6}$, die Farbdichtewerte $D_{Y21}$ und $D_{Y22}$ zwischen den Farbdichtewerten $D_{Y17}$ und $D_{Y15}$ sowie der Farbdichtewert $D_{Y23}$ zwischen den Farbdichtewerten $D_{Y9}$ und $D_{Y14}$.

Anschliessend erfolgt die Ebenen-Interpolation parallel zur Seite 89 zwischen den Farbdichtewerten der Seite 88 und denen der Flächennormalen 86, im einzelnen werden die Farbdichtewerte $D_{Y24}$, $D_{Y25}$ und $D_{Y26}$ zwischen den Farbdichtewerten $D_{Y7}$ und $D_{Y8}$, die Farbdichtewerte $D_{Y17}$, $D_{Y27}$ und $D_{Y28}$ zwischen den Farbdichtewerten $D_{Y18}$ und $D_{Y12}$ sowie der Farbdichtewert $D_{Y29}$ zwischen den Farbdichtewerten $D_{Y9}$ und $D_{Y11}$.

Die Farbdichtewerte können durch eine beliebige Interpolations-Methode, z.B. durch eine lineare Interpolation oder durch eine Interpolation nach Newton, ermittelt werden. Als besonders zweckmässig hat es sich erwiesen, die Spline-Interpolation anzuwenden, weil dadurch besonders glatte Kurvenverläufe zwischen den Stützwerten erzeugt werden.

Die Spline-Funktion gewährleistet noch nicht, dass die interpolierte Kurve durch monotone Stützwerte auch monoton verläuft. Jedoch gilt, dass die wahre Funktion um so besser angenähert wird, je kleiner die Werte der ersten Ableitung sind.

Bei monotonen Kurven liegt die maximale Steigung im Bereich 0 bis $+\infty$ (steigen) bzw. 0 bis $-\infty$ (fallen). Durch Drehung des Koordinatensystems kann man den Wertebereich der ersten Ableitung auf den Bereich $-1$ bis $+1$ reduzieren. Das geschieht durch Angleichung der Urbild- und Bild-Achse auf gleiche Masszahlen und durch Drehung der Urbild-Achse auf die Gerade durch Anfangs- und Endwert. Nach der Interpolation muss eine Rückdrehung des Koordinatensystems erfolgen.

Nachdem alle Farbdichtewerte für das Stützpunkt-Netz 70 des Druck-Farbraumes 66 bestimmt sind, werden sie in den Stützpunkt-Speicher der Interpolations-Stufe 21 in dem Farbumsetzer 16 des Proof-Recorders 10 geladen (Fig. 2).

Danach kann die Aufzeichnung der farbidentischen Proofs beginnen, wozu die entsprechenden Farbauszugswerte der Proofs aus dem Speichermedium 1 ausgelesen und dem Proof-Recorder 10 zugeführt werden.

## Patentansprüche

1. Verfahren zum punkt- und zeilenweisen Aufzeichnen eines Farbbildes von einem Farboriginal auf einem Farbmaterial mit einer Farb-Aufzeichnungseinheit zur Qualitätskontrolle beim Mehrfarbendruck, wobei die auf dem Farbmaterial aufgezeichneten Farben des Farbbildes mit den auf einem Druckmedium gedruckten Farben des Mehrfarbendrucks des Farboriginals übereinstimmen, dadurch gekennzeichnet, dass vor der Farbbild-Aufzeichnung

a) aus einem messtechnischen oder visuellen Vergleich von aufgezeichneten Farben eines Probe-Farbbildes, die durch Farbdichtewerte gekennzeichnet sind, mit gedruckten Farben eines Probe-Mehrfarbendrucks, die durch Farbauszugswerte gekennzeichnet sind, die für die Aufzeichnung eines mit dem Mehrfarbendruck farbäquivalenten Farbbildes auf dem Farbmaterial (11) erforderlichen Soll-Farbdichtewerte ($D_Y$, $D_M$, $D_C$) ermittelt werden, indem

$a_1$) Farben (72) des Farbraumes (73) des Farbmaterials (11) (Film-Farbraum) auf das für die spätere Aufzeichnung des Farbbildes vorgesehene Farbmaterial (11) mit maximalen Farbdichtewerten ($D_{Ymax}$, $D_{Mmax}$, $D_{Cmax}$) als Probe-Farbbild aufgezeichnet und für jede aufgezeichnete Farbe entsprechende Farb-Kennzeichnungswerte ($\overline{X}_{Fmax}$, $\overline{Y}_{Fmax}$, $\overline{Z}_{Fmax}$) bestimmt werden,

$a_2$) Farben (64, 65) des Farbraumes (66) des Mehrfarbendrucks (Druck-Farbraum) auf das für den Mehrfarbendruck des Farboriginals vorgesehene Druckmedium (8, 9) unter Fortdruckbedingungen als Probe-Mehrfarbendruck gedruckt und für jede gedruckte Farbe entsprechende Farb-Kennzeichnungswerte ($\overline{X}_D$, $\overline{Y}_D$, $\overline{Z}_D$) bestimmt werden,

$a_3$) die Farb-Kennzeichnungswerte ($\overline{X}_{Fmax}$, $\overline{Y}_{Fmax}$, $\overline{Z}_{Fmax}$) jeder aufgezeichneten Farbe des Probe-Farbbildes durch Änderung der maximalen Farbdichtewerte ($D_{Ymax}$, $D_{Mmax}$, $D_{Cmax}$) dieser Farbe an die Farb-Kennzeichnungswerte ($\overline{X}_D$, $\overline{Y}_D$, $\overline{Z}_D$) der zugehörigen gedruckten Farbe des Probe-Mehrfarbendrucks angeglichen werden, wobei die zur Angleichung der Farb-Kennzeichnungswerte erforderlichen Farbdichtewerte die Soll-Farbdichtewerte ($D_Y$, $D_M$, $D_C$) darstellen,

b) die Farbauszugswerte (Y, M, C) von Farben des Druck-Farbraumes (66) und die Soll-Farbdichtewerte ($D_Y$, $D_M$, $D_C$) der farbäquivalenten Farben des Film-Farbraumes (73) paarweise einander zugeordnet werden,

c) mit der Farb-Aufzeichnungseinheit (13) eine Farbdichte-Linearisierung des Farbmaterials (11) durchgeführt wird, indem zu jedem Soll-Farbdichtewert ($D_Y$, $D_M$, $D_C$) derjenige Istwert ermittelt wird, mit dem die dem Soll-Farbdichtewert ($D_Y$, $D_M$, $D_C$) entsprechende Farbdichte auf dem Farbmaterial (11) erreicht wird,
während der Farbbild-Aufzeichnung

d) die Farbauszugswerte (Y, M, C, K) des Farboriginals und die zur farbäquivalenten Aufzeichnung des Farbbildes erforderlichen Soll-Farbdichtewerte ($D_Y$, $D_M$, $D_C$) aufgerufen werden,

e) die aufgerufenen Soll-Farbdichtewerte ($D_Y$, $D_M$, $D_C$) unter Berücksichtigung der zugehörigen Istwerte in Ansteuerwerte (r, g, b) für die Farb-Aufzeichnungseinheit (13) umgewandelt werden und

f) die Farb-Aufzeichnungseinheit (13) das Farbbild punkt- und zeilenweise auf das Farbmaterial (11) aufzeichnet.

2. Verfahren nach Anspruch 1, dadurch gekennzeichnet, dass das Probe-Farbbild (gemäss Merkmal $a_1$ des Anspruchs 1) aufgezeichnet wird, indem

$a_{11}$) die maximalen Farbdichtewerte ($D_{Ymax}$, $D_{Mmax}$, $D_{Cmax}$) von Farben (72) des Film-Farbraumes (73) aufgerufen und in Ansteuerwerte (r, g, b) für die Farb-Aufzeichnungseinheit (13) umgewandelt werden und

$a_{12}$) die Farb-Aufzeichnungseinheit (13) die Farben (72) auf das Farbmaterial (11) punkt- und zeilenweise aufzeichnet.

3. Verfahren nach Anspruch 1 oder 2, dadurch gekennzeichnet, dass der Probe-Mehrfarbendruck (gemäss Merkmal $a_2$ des Anspruchs 1) gedruckt wird, indem

$a_{21}$) von den Farbauszugswerten (Y*, M*, C*, K*) der Farben (64; 65) des Druck-Farbraumes (66) Druckformen (4; 5) über die Farbauszüge hergestellt werden und

$a_{22}$) von den hergestellten Druckformen (4; 5) die Farben des Probe-Mehrfarbendrucks mit der für den Mehrfarbendruck vorgesehenen Druckmaschine (6; 7) und Druckart auf das Druckmedium (8; 9) gedruckt werden.

4. Verfahren nach Anspruch 3, dadurch gekennzeichnet, dass die Druckformen (4; 5) für den Offset-Druck mittels eines Farbscanners hergestellt werden.

5. Verfahren nach Anspruch 3, dadurch gekennzeichnet, dass die Druckformen (4; 5) für den Tiefdruck mittels einer Graviermaschine hergestellt werden.

6. Verfahren nach einem der Ansprüche 1 bis 5, dadurch gekennzeichnet, dass als Farb-Kennzeichnungswerte der aufgezeichneten und gedruckten Farben (gemäss den Merkmalen $a_1$ und $a_2$ des Anspruchs 1) die Normfarbwerte $(\overline{X}, \overline{Y}, \overline{Z})$ bestimmt werden.

7. Verfahren nach Anspruch 6, dadurch gekennzeichnet, dass die Normfarbwerte $(\overline{X}, \overline{Y}, \overline{Z})$ über die spektralen Remissionswerte ermittelt werden.

8. Verfahren nach einem der Ansprüche 1 bis 7, dadurch gekennzeichnet, dass zur Angleichung der Farb-Kennzeichnungswerte $(\overline{X}_{Fmax}, \overline{Y}_{Fmax}, \overline{Z}_{Fmax})$ der aufgezeichneten Farben des Probe-Farbbildes an die Farb-Kennzeichnungswerte $(X_D, Y_D, Z_D)$ der gedruckten Farben des Probe-Mehrfarbendrucks (gemäss Merkmal $a_3$ des Anspruchs 1) eine iterative Näherung durchgeführt wird, bei der ein Näherungsschritt wie folgt abläuft:

$a_{31}$) Ermitteln der vektoriellen Abstände des Farbortes der gedruckten Farbe (Druck-Farbort) zu den Farborten der belichteten Farben (Film-Farbort) im Normfarbwert-Koordinaten-System und Feststellen des am nächsten liegenden Film-Farbortes;

$a_{32}$) Bilden der Normfarbwert-Differenzen zwischen dem Druck-Farbort und dem am nächsten liegenden Film-Farbort und Feststellen der grössten Normfarbwert-Differenz;

$a_{33}$) Abändern der Soll-Farbdichtewerte in der Weise, dass die maximale Normfarbwert-Differenz zu Null wird;

$a_{34}$) Berechnen der Normfarbwerte eines durch die Farbdichte-Änderung gewonnenen und an den Druck-Farbort angenäherten neuen Film-Farbortes und

$a_{35}$) Durchführen eines weiteren Näherungsschrittes mit dem neuen Film-Farbort.

9. Verfahren nach einem der Ansprüche 1 bis 8, dadurch gekennzeichnet, dass die Zuordnung von Farbauszugswerten (Y, M, C) und Soll-Farbdichtewerten $(D_Y, D_M, D_C)$ (gemäss Merkmal b des Anspruchs 1) unter Berücksichtigung der vom späteren Druckprozess abhängigen Druck-Gradationskurve erfolgt.

10. Verfahren nach einem der Ansprüche 1 bis 9, dadurch gekennzeichnet, dass die Zuordnung (gemäss Merkmal b des Anspruchs 1) von Farbauszugswerten (Y, M, C) und Soll-Farbdichtewerten $(D_Y, D_M, D_C)$ vor der Farbbild-Aufzeichnung für alle theoretisch möglichen Farben des Druck-Farbraumes vorgenommen wird.

11. Verfahren nach einem der Ansprüche 1 bis 9, dadurch gekennzeichnet, dass

a) die Zuordnung (gemäss Merkmal b des Anspruchs 1) von Farbauszugswerten (Y, M, C) und Soll-Farbdichtewerten $(D_Y, D_M, D_C)$ vor der Farbbild-Aufzeichnung nur für einen Teil der theoretisch möglichen Farben des Druck-Farbraumes (Stützpunktnetz) vorgenommen wird und

b) die anstelle der aufgerufenen Farbauszugswerte (Y, M, C, K) des Farboriginals (gemäss Merkmal d des Anspruchs 1) für eine farbäquivalente Aufzeichnung auszugebenden Soll-Farbdichtewerte $(D_Y, D_M, D_C)$ durch eine Interpolation im Stützpunktnetz während der Farbbild-Aufzeichnung gewonnen werden.

12. Verfahren nach einem der Ansprüche 1 bis 11, dadurch gekennzeichnet, dass

a) die zu druckenden Farben des Probe-Mehrfarbendrucks (gemäss Merkmal $a_2$ des Anspruchs 1) aus den Farben des Druck-Farbraumes ausgewählt werden,

b) für jede ausgewählte zu druckende Farbe (gemäss Merkmal $a_3$ des Anspruchs 1) die Soll-Farbdichtewerte $(D_Y, D_M, D_C)$ ermittelt werden und

c) die Soll-Farbdichtewerte für weitere Farben des Druck-Farbraumes durch Interpolation aus den ermittelten Soll-Farbdichtewerten berechnet werden.

13. Verfahren nach Anspruch 12, dadurch gekennzeichnet, dass als zu druckende Farben des Probe-Mehrfarbendrucks die Eckfarben des Druck-Farbraumes ausgewählt werden.

14. Verfahren nach Anspruch 13, dadurch gekennzeichnet, dass als zu druckende Farben des Probe-Mehrfarbendrucks zusätzlich zu den Eckfarben weitere Farben auf der Grauachse und Zwischenfarben auf den Kanten des Druck-Farbraumes ausgewählt werden.

15. Verfahren nach Anspruch 12, 13 oder 14, dadurch gekennzeichnet, dass die Berechnung der Soll-Farbdichtewerte für weitere Farben des Druck-Farbraumes aus den ermittelten Soll-Farbdichtewerten der aufgezeichneten Farben in folgenden Interpolations-Schritten abläuft:

a) Bestimmen der zuzuordnenden Farbdichtewerte für alle auf den Kanten des Druck-Farbraumes liegenden Farborte aus den Farbdichtewerten, welche bereits den Farborten der entsprechenden Kanten zugeordnet wurden, durch eine erste Interpolation;

b) Unterteilen des Druck-Farbraumes in parallele Farbort-Ebenen, und zwar in

$b_1$) Gelb-Ebenen, für welche die Gelb-Achse des Druck-Farbraumes Flächennormale ist,

$b_2$) Magenta-Ebenen, für welche die Magenta-Achse des Druck-Farbraumes Flächennormale ist, und in

$b_3$) Cyan-Ebenen, für welche die Cyan-Achse des Druck-Farbraumes Flächennormale ist;

c) in jeder Ebene Bestimmen der zugeordneten Farbdichtewerte für alle auf den Kanten der Farbort-Ebenen liegenden Farborte aus den Farbdichtewerten, welche bereits Farborten auf den betreffenden Kanten zugeordnet wurden, durch eine zweite Interpolation;

d) in jeder Farbort-Ebene Bestimmen der zuzuordnenden Farbdichtewerte für alle auf einer der Diagonalen der Farbort-Ebene liegenden Farborte aus den Farbdichtewerten, die bereits Farborten auf den Diagonalen zugeordnet wurden, durch eine dritte Interpolation;

e) in jeder Farbort-Ebene Bestimmen der zuzuordnenden Farbdichtewerte für alle auf parallel zu den Kanten der Farbort-Ebene und jeweils zwischen den Kanten und der Diagonalen liegenden Farborte aus Farbdichtewerten, welche bereits den Farborten auf den Kanten und den Diagonalen zugeordnet sind.

16. Verfahren nach Anspruch 15, dadurch gekennzeichnet, dass die Interpolation mittels Spline-Funktionen durchgeführt wird.

17. Verfahren nach einem der Ansprüche 1 bis 16, dadurch gekennzeichnet, dass

a) die Soll-Farbdichtewerte ($D_Y$, $D_M$, $D_C$) den nach einer vom späteren Druckprozess abhängigen Druck-Gradationskurve modifizierten Farbauszugswerten (gemäss Merkmal b des Anspruchs 1) zugeordnet werden und

b) die (gemäss Merkmal d des Anspruchs 1) aufgerufenen Farbauszugswerte (Y, M, C, K) des Farboriginals nach der Druck-Gradationskurve modifiziert werden und die modifizierten Farbauszugswerte die entsprechenden Soll-Farbdichtewerte ($D_Y$, $D_M$, $D_C$) aufrufen.

18. Verfahren nach einem der Ansprüche 1 bis 17, dadurch gekennzeichnet, dass

a) die Soll-Farbdichtewerte ($D_Y$, $D_M$, $D_C$) den Farbauszugswerten (Y, M, C) der bunten Farbauszüge (gemäss Merkmal b des Anspruchs 1) zugeordnet werden und

b) beim Aufrufen der Farbauszugswerte (Y, M, C, K) des Farboriginals (gemäss Merkmal d des Anspruchs 1) aus den Farbauszugswerten (K) für den unbunten Farbauszug Schwarzwerte berechnet und den den Farbauszugswerten (Y, M, C) der bunten Farbauszüge zugeordneten Soll-Farbdichtewerten ($D_Y$, $D_M$, $D_C$) überlagert werden.

19. Verfahren nach einem der Ansprüche 1 bis 18, dadurch gekennzeichnet, dass die Farbdichte-Linearisierung des Farbmaterials (11) (gemäss Merkmal c des Anspruchs 1) durchgeführt wird, indem

$c_1$) gestufte Soll-Farbdichtewerte ($D_Y$, $D_M$, $D_C$) vorgegeben und in Ansteuerwerte (r, g, b) für die Farb-Aufzeichnungseinheit (13) umgewandelt werden, wobei die Ansteuerwerte die Lichtenergien des farbigen Lichtes der Farb-Aufzeichnungseinheit (13) bestimmen,

$c_2$) mit den Ansteuerwerten (r, g, b) Farbkeile auf das Farbmaterial (11) aufgezeichnet werden,

$c_3$) die aufgezeichneten Farbkeile zur Bestimmung der Istwerte dichtemässig ausgemessen werden und

$c_4$) gleichzeitig anhand der Farbkeile die zum Erreichen einer möglichst grossen Farbsättigung auf dem Farbmaterial (11) erforderlichen maximalen Farbdichtewerte ($D_{Ymax}$, $D_{Mmax}$, $D_{Cmax}$) ermittelt werden.

20. Verfahren nach einem der Ansprüche 1 bis 19, dadurch gekennzeichnet, dass zur Aufzeichnung des Farbbildes Laserlicht verwendet wird.

21. Anordnung zur Aufzeichnung von Farbbildern auf Farbmaterial mit Licht bestimmter Spektralverteilung für die Qualitätskontrolle beim Mehrfarbendruck, gekennzeichnet durch

a) eine Ansteuerschaltung (12) zur Erzeugung von Ansteuerwerten (r, g, b) aus Farbauszugswerten (Y, M, C, K), bestehend aus:

$a_1$) einem Farbumsetzer (16), welcher mit Farbauszugswerten beaufschlagt ist, zur Erzeugung von Farbdichtewerten ($D_Y$, $D_M$, $D_C$) aus den Farbauszugswerten, wobei die Farbdichtewerte ein Mass für die zur farbäquivalenten Farbbild-Aufzeichnung erforderlichen Farbdichten auf dem Farbmaterial sind,

$a_2$) eine Linearisierungs-Stufe (17), welche mit dem Farbumsetzer (16) in Verbindung steht, zur Farbdichte-Linearisierung des Farbmaterials, und

$a_3$) einerm D/A-Wandler (19), welcher an die Linearisierungs-Stufe (17) angeschlossen ist, zur Umwandlung der durch die Farbdichte-Linearisierung geänderten Farbdichtewerte in die Ansteuerwerte; und durch

b) eine Farb-Aufzeichnungseinheit (13), welche mit der Ansteuerschaltung (12) verbunden ist, bestehend aus:

$b_1$) mindestens einer Lichtquelle (32; 33; 34) zur Erzeugung von Licht mit drei Spektralkomponenten,

$b_2$) Lichtmodulatoren (38; 39; 40), welche im Lichtweg angeordnet und mit den Ansteuerwerten beaufschlagt sind, um die Intensitäten der drei Spektralkomponenten in Abhängigkeit der Ansteuerwerte zu ändern,

$b_3$) optischen Mitteln (56; 57; 58; 60) zur Fokussierung des Lichtes auf das Farbmaterial (11); und durch

c) einen Aufzeichnungsträger (14) für das Farbmaterial (11), welcher relativ zur Farb-Aufzeichnungseinheit (13) bewegbar ist.

22. Anordnung nach Anspruch 21, dadurch gekennzeichnet, dass dem Farbumsetzer (16) eine Gradationsstufe (15) vorgeschaltet ist, um die Farbauszugswerte nach einer vom späteren Druckprozess abhängigen Gradations-Kurve zu modifizieren.

23. Anordnung nach Anspruch 21 oder 22, dadurch gekennzeichnet, dass der Farbumsetzer (16) folgende Komponenten aufweist:

a) eine Zuordnungs-Einrichtung (21) für Farbdichtewerte ($D_Y$, $D_M$, $D_C$) und Farbauszugswerte (Y, M, C),

b) einen Schwarzwert-Rechner (23) zur Berechnung von Schwarzwerten aus den Farbauszugswerten (K) für den Farbauszug Schwarz und

c) eine Überlagerungsstufe (24), welche an die Zuordnungs-Einrichtung (21) und den Schwarzwert-Rechner (23) angeschlossen ist, um den Farbdichtewerten ($D_Y$, $D_M$, $D_C$) die errechneten Schwarzwerte zu überlagern.

24. Anordnung nach Anspruch 23, dadurch gekennzeichnet, dass die Zuordnungs-Einrichtung (21) aus einem Zuordnungs-Speicher für Farbdichtewerte ($D_Y$, $D_M$, $D_C$) und Farbauszugswerte (Y, M, C) und einer Interpolationsstufe besteht.

25. Anordnung nach einem der Ansprüche 21 bis 24, dadurch gekennzeichnet, dass die Ansteuerschaltung (12) einen Farbkeil-Generator (20) aufweist, welcher an die Linearisierungs-Stufe (17) anschliessbar ist, um zur Belichtung von Farbkeilen auf dem Farbmaterial Farbdichtewerte aufzurufen.

26. Anordnung nach einem der Ansprüche 21 bis 25, dadurch gekennzeichnet, dass die Lichtquelle mindestens ein Laser ist.

## Claims

1. Process for dot-by-dot and line-by-line reproduction of a colour image from a colour original on to a colour material with a colour recording unit for quality control in the course of multicolour printing, the colours of the colour image reproduced on the colour material corresponding to the colours of the multicolour print of the colour original printed on to a printing medium, characterized in that prior to the colour image reproduction,

a) the nominal colour density values ($D_Y$, $D_M$, $D_C$) required for the reproduction of a colour image chromatically equivalent to the multicolour print on the colour material (11) are determined by a comparison by mensuration techniques or by eye, between recorded colours of a sample colour image and printed colours of a sample multicolour print which are characterized by colour separation values, by means of

$a_1$) recording colours (72) of the colour space (73) of the colour material (11) (film colour space) on to the colour material (11) provided for subsequent reproduction of the colour image with maximum colour density values ($D_{Ymax}$, $D_{Mmax}$, $D_{Cmax}$) as a sample colour image, and determining colour characteristic values $\overline{X}_{Fmax}$, $\overline{Y}_{Fmax}$, $\overline{Z}_{Fmax}$) corresponding to each colour recorded,

$a_2$) printing colours (64, 65) of the colour space (66) of the multicolour print (print colour space) on to the printing medium (8, 9) provided for the multicolour print of the colour original under run-on conditions as a sample multicolour print, and determining corresponding colour characteristic values ($\overline{X}_D$, $\overline{Y}_D$, $\overline{Z}_D$) for each colour printed,

$a_3$) matching the colour characteristic values ($\overline{X}_{Fmax}$, $\overline{Y}_{Fmax}$, $\overline{Z}_{Fmax}$) of each recorded colour of the sample colour image by varying the maximum colour density values ($D_{Ymax}$, $D_{Mmax}$, $D_{Cmax}$) of this colour to the colour characteristic values ($\overline{X}_D$, $\overline{Y}_D$, $\overline{Z}_D$) of the corresponding printed colour of the sample multicolour print, the colour density values required for matching the colour characteristic values representing the nominal density values ($D_Y$, $D_M$, $D_C$),

b) the colour separation values (Y, M, C) of colours of the print colour space (66) and the nominal colour density values ($D_Y$, $D_M$, $D_C$) of the colour equivalent colours of the film colour space (73) are co-ordinated with each other in pairs,

c) a colour density linearization of the colour material (11) is performed with the colour recording unit (13) by determining the actual value at which the colour density corresponding to the nominal colour density value ($D_Y$, $D_M$, $D_C$) is obtained for each nominal colour density value ($D_Y$, $D_M$, $D_C$) on the colour material (11), during the colour image recording,

d) the colour separation values (Y, M, C, K) of the colour original and the nominal colour density values ($D_Y$, $D_M$, $D_C$) required for the colour-equivalent recording of the colour image are called up,

e) the addressed nominal colour density values ($D_Y$, $D_M$, $D_C$) are converted into control values (r, g, b) for the colour recording unit (13) under consideration of the corresponding actual values, and

f) the colour recording unit (13) records the colour image on the colour material (11) dot-by-dot and line-by-line.

2. Process according to claim 1, characterized in that the sample colour image is recorded (according to feature $a_1$ of claim 1), by

$a_{11}$) addressing the maximum colour density values ($D_{Ymax}$, $D_{Mmax}$, $D_{Cmax}$) of colours (72) of the film colour space (73) and converting these into control values (r, g, b) for the colour recording unit (13), and

$a_{12}$) recording the colours (72) on to the colour material (11) dot-by-dot and line-by-line by the colour recording unit (13).

3. Process according to claim 1 or 2, characterized in that the sample multicolour print is printed (according to feature $a_2$ of claim 1), by

$a_{21}$) producing printing formes (4; 5) in respect of the colour separations from the colour separation values (Y*, M*, C*, K*) of the colour (64, 65) of the print colour space (66), and

$a_{22}$) printing the colours of the sample multicolour print on to the printing medium (8, 9) with the printing machine (6; 7) rigged for multicolour printing and the corresponding printing method, by means of the printing formes (4; 5) produced.

4. Process according to claim 3, characterized in that the printing formes (4; 5) are produced for offset printing by means of a colour scanner.

5. Process according to claim 3, characterized in that the printing formes (4; 5) are produced for gravure printing by means of a gravure machine.

6. Process according to one of the claims 1 to 5, characterized in that the standard colour values $\overline{X}$, $\overline{Y}$, $\overline{Z}$) are determined as the colour characteristic values of the colours recorded and printed (according to features $a_1$ and $a_2$ of claim 1).

7. Process according to claim 6, characterized in that the standard colour values ($\overline{X}$, $\overline{Y}$, $\overline{Z}$) are determined by means of the spectroscopic reflectance values.

8. Process according to one of the claims 1 to 7, characterized in that for the purpose of matching the colour characteristic values $\overline{X}_{Fmax}$, $\overline{Y}_{Fmax}$, $\overline{Z}_{Fmax}$) of the recorded colours of the sample colour image to the colour characteristic values $\overline{X}_D$, $\overline{Y}_D$, $\overline{Z}_D$) of the printed colours of the sample multicolour print (according to feature $a_3$ of claim 1), an iterative approximation is performed, in which an approximation step evolves as follows:

$a_{31}$) finding the vectorial distances of the colour locus of the printed colour (print colour locus) from the colour loci of the exposed colours (film colour locus) in the standard colour value coordinate system and establishing the closest film colour locus;

$a_{32}$) determining the standard colour value differences between the print colour locus and the nearest film colour locus and establishing the maximum standard colour value difference;

$a_{33}$) modifying the nominal colour density values, in such manner that the maximum standard colour value difference drops to zero;

$a_{34}$) calculating the standard colour values of a new film colour locus obtained by colour density variation and approximated to the print colour locus, and

$a_{35}$) performing another approximation step with the new film colour locus.

9. Process according to one of the claim 1 to 8, characterized in that the co-ordination between colour separation values (Y, M, C) and nominal colour density values ($D_Y$, $D_M$, $D_C$) (according to feature b of claim 1) is performed under consideration of the print gradation graph dependent on the subsequent printing process.

10. Process according to one of the claims 1 to 9, characterized in that the co-ordination (according to feature b of claim 1) between colour separation values (Y, M, C) and nominal colour density values ($D_Y$, $D_M$, $D_C$) is performed prior to the colour image recording for all theoretically possible colours of the print colour space.

11. Process according to one of the claims 1 to 9, characterized in that

a) the co-ordination (according to feature b of claim 1) between colour separation values (Y, M, C) and nominal colour density values ($D_Y$, $D_M$, $D_C$) is performed prior to the colour image recording for only a part of the theoretically possible colours of the print colour space (anchor point grid), and

b) the nominal colour density values ($D_Y$, $D_M$, $D_C$) which are to be issued for a colour-equivalent recording instead of the addressed colour separation values (Y, M, C, K) of the colour original (according to feature d of claim 1) are obtained by an interpolation in the anchor point grid during the colour image recording.

12. Process according to one of the claims 1 to 11, characterized in that

a) the colours of the sample multicolour print which are to be printed (according to feature $a_2$ of claim 1), are selected from the colours of the print colour space,

b) the nominal colour density values ($D_Y$, $D_M$, $D_C$) are determined for each selected colour which is to be printed (according to feature $a_3$ of claim 1), and

c) the nominal colour density values are calculated for other colours of the print colour space by interpolation from the nominal colour density values determined.

13. Process according to claim 12, characterized in that the corner colours of the print colour space are selected as the colours of the sample multicolour print which are to be printed.

14. Process according to claim 13, characterized in that other colours on the grey axis and intermediate colours at the edges of the print colour space are selected in addition to the corner colours, as the colours of the sample multicolour print which are to be printed.

15. Process according to claim 12, 13, or 14, characterized in that the calculation of the nominal colour density values for additional colours of the print colour space from the nominal colour density values determined for the recorded colours is implemented by the following interpolation steps:

a) determining the colour density values which are to be co-ordinated, for all the colour loci situated at the edges of the print colour space from the colour density values which had already been allocated to the colour loci for the corresponding edges, by a first interpolation;

b) dividing the print colour space into parallel colour locus planes, that is to say into

$b_1$) yellow planes, for which the yellow axis of the print colour space is at right angles to their surface,

$b_2$) magenta planes, for which the magenta axis of the print colour space is at right angles to their surface, and

$b_3$) cyan planes, for which the cyan axis of the print colour space is at right angles to their surface;

c) in each plane, determining the co-ordinated colour density values for all the colour loci situated at the edges of the colour locus planes from the colour density values which had already been allocated to colour loci at the edges in question, by a second interpolation;

d) in each colour locus plane, determining the colour density values to be co-ordinated, for all the colour loci situated on one of the diagonals of the colour locus plane, from the colour density values which had already been allocated to colour loci on the diagonals, by a third interpolation;

e) in each colour locus plane, determining the colour density values to be co-ordinated, for all the colour loci situated parallel to the edges of the colour locus plane and in each case between the edges and the diagonals, from colour density values which are already allocated to the colour loci at the edges and on the diagonals.

16. Process according to claim 15, characterized in that the interpolation is performed by means of «Spline» functions.

17. Process according to one of the claims 1 to 16, characterized in that

a) the nominal colour density values ($D_Y$, $D_M$, $D_C$) are co-ordinated with the colour separation values modified according to a print gradation graph dependent on the subsequent printing process (according to feature b of claim 1), and

b) the colour separation values (Y, M, C, K) of the colour original which are address (according to feature d of claim 1) are modified as a function of the print gradation graph and the modified colour separation values call up the corresponding nominal colour density values ($D_Y$, $D_M$, $D_C$).

18. Process according to one of the claims 1 to 17, characterized in that

a) the nominal colour density values ($D_Y$, $D_M$, $D_C$) are allocated to the colour separation values (Y, M, C) of the chromatic colour separations (according to feature b of claim 1), and

b) upon calling up the colour separation values (Y, M, C, K) of the colour original (according to feature d of claim 1) black values are calculated from the colour separation values (K) for the achromatic colour separation and are superimposed on the nominal colour density values ($D_Y$, $D_M$, $D_C$)

allocated to the colour separation values (Y, M, C) of the chromatic colour separations.

19. Process according to one of the claims 1 to 18, characterized in that the colour density linearization of the colour material (11) is performed (according to feature c of claim 1), by

$c_1$) presetting stepped nominal colour density values ($D_Y$, $D_M$, $D_C$) and converting these into control values (r, g, b) for the colour recording unit (13), the control values determining the light energies of the chromatic light of the colour recording unit (13),

$c_2$) colour wedges are recorded on the colour material (11) with the control values (r, g, b),

$c_3$) the colour wedges recorded are measured in respect of density for determining the actual values, and

$c_4$) the maximum colour density values ($D_{Ymax}$, $D_{Mmax}$, $D_{Cmax}$) required to secure an optimum colour intensity on the colour material (11) are determined at the same time under reference to the colour wedges.

20. Process according to one of the claims 1 to 19, characterized in that laser light is utilized for recording the colour image.

21. System for recording colour images on a colour material by light with a determined spectral destribution for quality control during multicolour printing, characterized by

a) a control circuit (12) for generating control values (r, g, b) from colour separation values (Y, M, C, K), comprising:

$a_1$) a colour converter (16) which is supplied with colour separation values, for generating colour density values ($D_Y$, $D_M$, $D_C$) from the colour separation values, the colour density values being a criterion for the colour densities on the colour-equivalent colour image recording on the colour material,

$a_2$) a linearization stage (17) which is in communication with the colour converter (16) for colour density linearization of the colour material, and

$a_3$) a digital/analog converter (19) which is connected to the linearization stage (17) to convert the colour density values modified by the colour density linearization into the control values; and

b) a colour recording unit (13) which is connected to the control circuit (12), comprising:

$b_1$) at least one light source (32; 33; 34) for generating light having three spectrum components,

$b_2$) light modulators (38; 39; 40) which are placed in the light path and acted upon by the control values, to vary the intensities of the three spectral components as a function of the control values,

$b_3$) optical means (56; 57; 58; 60) for focusing the light on the colour material (11), and by

c) a record carrier (14) for the colour material (11) which is movable with respect to the colour recording unit (13).

22. System according to claim 21, characterized in that a gradation stage (15) is preconnected to the colour converter (16), to vary the colour separation values according to a gradation graph affected by a subsequent printing process.

23. System according to claim 21 or 22, characterized in that the colour converter (16) has the following components:

a) a co-ordinator device (21) for colour density values ($D_Y$, $D_M$, $D_C$) and colour separation values (Y, M, C)

b) a black value computer (23) for calculation of black values for the «black» colour separation, from the colour separation values (K), and

c) a superimposition stage (24) which is connected to the co-ordinator device (21) and to the black value computer (23) so that the black values calculated are superimposed on the colour density values ($D_Y$, $D_M$, $D_C$).

24. System according to claim 23, characterized in that the co-ordinator device (21) comprises a co-ordinator memory for colour density values ($D_Y$, $D_M$, $D_C$) and colour separation values (Y, M, C), and an interpolator stage.

25. System according to one of the claims 21 to 24, characterized in that the control circuit (12) has a colour wedge generator (20) which may be connected to the linearizing stage (17) for addressing colour density values for exposure of colour wedges on the colour material.

26. System according to one of the claims 21 to 25, characterized in that the light source is at least one laser.

**Revendications**

1. Procédé pour l'inscription point par point et ligne par ligne d'une image en couleur d'un original en couleur sur un support en couleur à l'aide d'une unité d'inscription en couleur pour le contrôle de qualité d'une impression polychrome, les couleurs inscrites sur le support de couleur de l'image en couleur coïncidant avec les couleurs imprimées sur un support d'impression de l'impression polychrome de l'original en couleur, caractérisé en ce que, avant l'inscription de l'image,

a) à partir d'une comparaison visuelle ou faite par une technique de mesure entre les couleurs inscrites d'une image polychrome d'échantillon et qui sont caractérisées par les grandeurs des densités de couleur et des couleurs imprimées d'une impression polychrome d'échantillon, qui sont caractérisées par les grandeurs d'extrait de couleur, on détermine les grandeurs de consigne de densité de couleur ($D_Y$, $D_M$, $D_C$) nécessaires pour l'inscription d'une image de couleur sur un support de couleur (11) avec des couleurs équivalentes à l'impression polychrome, en ce que:

$a_1$) on inscrit les couleurs (72) de l'espace-couleur (73) du support de couleur (11) (espace-couleur du film) avec les grandeurs maximales de densités de couleur ($D_{Ymax}$, $D_{Mmax}$, $D_{Cmax}$) comme échantillons d'image de couleur sur le support couleur (11) prévu pour l'inscription ultérieure de l'image couleur et on détermine les grandeurs caractéristiques de couleur $\overline{X}_{Fmax}$, $\overline{Y}_{Fmax}$, $\overline{Z}_{Fmax}$) pour chaque couleur à inscrire,

$a_2$) on imprime les couleurs (64, 65) de l'espace-couleur (66) de l'impression polychrome (espace-couleur d'impression) sur le support d'impression (8, 9) prévu pour l'impression polychrome de l'original en couleur comme échantillons de l'impression polychrome aux conditions de l'impression continue, et on détermine les grandeurs caractéristiques de couleur $\overline{X}_D$, $\overline{Y}_D$, $\overline{Z}_D$) pour chaque couleur imprimée,

$a_3$) on adapte les grandeurs caractéristiques de couleur $\overline{X}_{Fmax}$, $\overline{Y}_{Fmax}$, $\overline{Z}_{Fmax}$) de chaque couleur inscrite de l'échantillon de l'image de couleur en modifiant les grandeurs maximales des densités de couleur ($D_{Ymax}$, $D_{Mmax}$, $D_{Cmax}$) de ces couleurs aux grandeurs caractéristiques de couleur $\overline{X}_D$, $\overline{Y}_D$, $\overline{Z}_D$) des couleurs imprimées correspondantes de l'échantillon d'impression polychrome, les grandeurs de densités de couleur, nécessaires pour l'adaptation des grandeurs caractéristiques de couleur représentant les densités de consigne de couleur ($D_Y$, $D_M$, $D_C$),

b) on associe par paire les grandeurs d'extrait de couleur (Y, M, C) des couleurs de l'espace-couleur d'impression (66) et les grandeurs de consigne de densités de couleur ($D_Y$, $D_M$, $D_C$) des couleurs équivalentes de l'espace-couleur du film (73),

c) à l'aide de l'unité d'inscription de couleur (13), on effectue une linéarisation de la densité de couleur du support-couleur (11) en déterminant la grandeur réelle correspondant à chaque grandeur de consigne de densité de couleur ($D_Y$, $D_M$, $D_C$), grandeur réelle qui donne sur le support-couleur (11) la densité de couleur correspondant à la grandeur de consigne de densité de couleur ($D_Y$, $D_M$, $D_C$), pendant l'inscription de l'image en couleur,

d) on appelle les grandeurs d'extrait de couleur (Y, M, C, K) de l'original en couleur et les grandeurs de consigne de densités de couleur ($D_Y$, $D_M$, $D_C$) nécessaires pour l'inscription de couleur équivalente à celle de l'image en couleur,

e) on transforme les grandeurs de consigne de densités de couleur ($D_Y$, $D_M$, $D_C$), appelées en tenant compte des grandeurs réelles correspondantes dans des grandeurs de commande (r, g, b) destinées à l'unité d'inscription de couleur (13), et

f) l'unité d'inscription de couleur (13) inscrit l'image couleur point par point et ligne par ligne sur le support-couleur (11).

2. Procédé selon la revendication 1, caractérisé en ce que l'échantillon de l'image en couleur (selon la caractéristique $a_1$ de la revendication 1) est inscrit en:

$a_{11}$) on appelle les grandeurs maximales des densités de couleur ($D_{Ymax}$, $D_{Mmax}$, $D_{Cmax}$) des couleurs (72) de l'espace-couleur (73) du film et on les transforme en grandeurs de commande (r, g, b) de l'unité d'inscription de couleur (13), et

$a_{12}$) l'unité d'inscription de couleur (13) inscrit point par point et ligne par ligne les couleurs (72) sur le support-couleur (11).

3. Procédé selon la revendication 1 ou 2, caractérisé en ce qu'on effectue l'impression polychrome de l'échantillon (selon la caractéristique $a_2$ de la revendication 1),

$a_{21}$) on réalise des matrices d'impression (4, 5) à partir des extraits de couleur provenant des grandeurs d'extrait de couleur (Y*, M*, C*, K*) des couleurs (64, 65) de l'espace-couleur d'impression (66) et

$a_{22}$) à l'aide des matrices d'impression (4, 5) ainsi réalisées, on imprime les couleurs de l'impression polychrome de l'échantillon à l'aide de la machine à imprimer (6, 7) prévue pour l'impression polychrome et suivant le mode d'impression sur le support d'impression (8, 9).

4. Procédé selon la revendication 3, caractérisé en ce que les matrices d'impression (4, 5) pour l'impression Offset sont réalisées à l'aide d'un dispositif de balayage de couleur.

5. Procédé selon la revendication 3, caractérisé en ce que les matrices d'impression (4, 5) pour l'impression en taille douce sont réalisées à l'aide d'une machine à graver.

6. Procédé selon l'une des revendications 1 à 5, caractérisé en ce qu'on détermine les grandeurs normales de couleur ($X$, $Y$, $Z$) comme grandeurs caractéristiques de couleur pour les couleurs inscrites et imprimées (selon les caractéristiques $a_1$ et $a_2$ de la revendication 1).

7. Procédé selon la revendication 6, caractérisé en ce qu'on détermine les grandeurs normales de couleur ($X$, $Y$, $Z$) par les grandeurs de rémissions spectrales.

8. Procédé selon l'une des revendications 1 à 7, caractérisé en ce que pour adapter les grandeurs caractéristiques de couleur $\overline{X}_{Fmax}$, $\overline{Y}_{Fmax}$, $\overline{Z}_{Fmax}$) des couleurs inscrites de l'échantillon d'image en couleur aux grandeurs caractéristiques de couleur ($\overline{X}_D$, $\overline{Y}_D$, $\overline{Z}_D$) des couleurs imprimées de l'échantillon en impression polychrome (selon la caractéristique $a_3$ de la revendication 1), on effectue une approximation par itération dans laquelle la phase d'approximation se déroule comme suit:

$a_{31}$) on détermine les distances vectorielles des écarts de l'emplacement de couleur de la couleur imprimée (emplacement de couleur d'impression) par rapport aux emplacements de couleur des couleurs éclairées (emplacements de couleur de film) dans un système de coordonnées de grandeurs de couleur normalisées et on détermine l'emplacement de couleur de film le plus proche;

$a_{32}$) on forme les différences de grandeurs normales de couleur entre l'emplacement de couleur d'impression et l'emplacement de couleur de film le plus proche et on détermine la plus grande différence de grandeurs normales de couleur;

$a_{33}$) on modifie la grandeur de consigne de densité de couleur de façon que la différence maximale normale de grandeurs de couleur soit nulle;

$a_{34}$) on calcule la grandeur normale de couleur d'un nouvel emplacement de couleur de film obtenu par changement de la densité de couleur et rapproché de l'emplacement de couleur d'impression, et

$a_{35}$) on effectue une étape d'approximation suivante avec un nouvel emplacement de couleur de film.

9. Procédé selon l'une des revendications 1 à 8, caractérisé en ce que l'association entre les grandeurs d'extrait de couleur (Y, M, C) et les grandeurs de consigne de densités de couleur ($D_Y$, $D_M$, $D_C$) (selon la caractéristique b de la revendication 1) se fait en tenant compte de la courbe de gradation d'impression dépendant du procédé d'impression ultérieur.

10. Procédé selon l'une des revendications 1 à 9, caractérisé en ce que l'association (selon la caractéristique b de la revendication 1) entre les grandeurs d'extrait de couleur (Y, M, C) et les grandeurs de densités de couleur ($D_Y$, $D_M$, $D_C$) est faite avant l'inscription de l'image en couleur pour toutes les couleurs théoriquement possibles de l'espace-couleur d'impression.

11. Procédé selon l'une des revendications 1 à 9, caractérisé en ce que:

a) l'association (selon la caractéristique b de la revendication 1) entre les grandeurs d'extrait de couleur (Y, M, C) et les grandeurs de consigne et de densités de couleur ($D_Y$, $D_M$, $D_C$) est faite avant l'inscription de l'image en couleur seulement pour une partie des couleurs théoriquement possibles de l'espace-couleur d'impression (réseau de points d'appui), et

b) on obtient par interpolation dans le réseau de points d'appui au cours de l'inscription de l'image en couleur, les grandeurs de consigne et de densités de couleur à fournir pour une inscription de couleur équivalente, à la place des grandeurs d'extrait de couleur, appelées (Y, M, C, K) de l'original en couleur (selon la caractéristique d de la revendication 1).

12. Procédé selon l'une des revendications 1 à 11, caractérisé en ce que:

a) on choisit les couleurs à imprimer de l'échantillon de l'impression polychrome (selon la caractéristique $a_2$ de la revendication 1) à partir des couleurs de l'espace-couleur d'impression,

b) pour chaque couleur à imprimer, choisie, (selon la caractéristique $a_3$ de la revendication 1) on détermine les grandeurs de consigne de densités de couleur ($D_Y$, $D_M$, $D_C$) et

c) on calcule les grandeurs de consigne de densités de couleur pour d'autres couleurs de l'espace-couleur d'impression par interpolation à partir des grandeurs de consigne de densités de couleur, déterminées.

13. Procédé selon la revendication 12, caractérisé en ce que comme couleurs à imprimer pour l'échantillon d'impression polychrome, on choisit les couleurs des coins de l'espace-couleur d'impression.

14. Procédé selon la revendication 13, caractérisé en ce qu'en plus des couleurs à imprimer de l'échantillon de l'impression polychrome, on choisit en plus des couleurs de coins, d'autres couleurs de l'axe des gris et des couleurs intermédiaires sur les bords de l'espace-couleur d'impression.

15. Procédé selon la revendication 12, 13 ou 14, caractérisé en ce que le calcul de la grandeur de consigne de densité de couleur pour les autres couleurs de l'espace-couleur d'impression se fait à partir des grandeurs de consigne de densités de couleur, déterminées, pour les couleurs inscrites, à partir des grandeurs de consigne de densités de couleur, déterminées correspondant aux couleurs inscrites, suivant les étapes d'interpolation suivantes:

a) on détermine les grandeurs de densités de couleur associées pour tous les emplacements de couleur situés sur les bords de l'espace-couleur d'impression à partir des grandeurs de densités de couleur qui ont déjà été associées aux emplacements de couleur des bords correspondants en procédant à une première interpolation,

b) on subdivise l'espace-couleur d'impression en des plans parallèles d'emplacements de couleur et cela en:

$b_1$) des plans de jaune pour lesquels l'axe de jaune de l'espace-couleur d'impression est la normale aux surfaces,

$b_2$) des plans de magenta pour lesquels l'axe de magenta de l'espace-couleur d'impression est la normale aux surfaces, et en

$b_3$) des plans de cyan pour lesquels l'axe de cyan de l'espace-couleur d'impression est la normale aux surfaces,

c) dans chaque plan, on détermine les grandeurs de densités de couleur associées pour tous les emplacements de couleur situés sur les bords des plans des emplacements de couleur, à partir des grandeurs de densités de couleur qui ont déjà été associées à des emplacements de couleur sur les bords correspondants, en procédant à une seconde interpolation,

d) dans chaque plan d'emplacement de couleur, on détermine les grandeurs correspondantes de densités de couleur pour tous les emplacements de couleur situés sur l'une des diagonales du plan des emplacements de couleur, à partir des grandeurs de densités de couleur qui ont déjà été associées aux emplacements de couleur sur les diagonales, en procédant à une troisième interpolation;

e) dans chaque plan d'emplacement de couleur, on détermine les grandeurs de densités de couleur correspondantes pour tous les emplacements de couleur situés dans des plans d'emplacements de couleur parallèles aux bords et respectivement entre les bords et les diagonales, à partir des grandeurs de densités de couleur qui ont déjà été associées aux emplacements de couleur sur les bords et les diagonales.

16. Procédé selon la revendication 15, caractérisé en ce qu'on effectue l'interpolation à l'aide de fonctions spline.

17. Procédé selon l'une des revendications 1 à 16, caractérisé en ce que:

a) on associe les grandeurs de consigne de densités de couleur ($D_Y$, $D_M$, $D_C$) aux grandeurs d'extrait de couleur modifiées (selon la caractéristique b de la revendication 1) selon la courbe de gradation d'impression dépendant du procédé d'impression ultérieur, et

b) on modifie les grandeurs d'extrait de couleur (Y, M, C, K) de l'original en couleur (selon la caractéristique d de la revendication 1), appelées en procédant selon la courbe de gradation d'impression et les grandeurs d'extrait de couleur, modifiées, appellent les grandeurs de consigne de densités de couleur ($D_Y$, $D_M$, $D_C$) correspondantes.

18. Procédé selon l'une des revendications 1 à 17, caractérisé en ce que:

a) on associe les grandeurs de consigne de densités de couleur ($D_Y$, $D_M$, $D_C$) aux grandeurs d'extrait de couleur (Y, M, C) des extraits de couleur, colorés (selon la caractéristique b de la revendication 1), et

b) par appel des grandeurs d'extrait de couleur (Y, M, C, K) de l'original en couleur (selon la caractéristique d de la revendication 1) on calcule les grandeurs de noir de l'extrait de couleur non coloré à partir des grandeurs d'extrait de couleur (K) et on les superpose aux grandeurs de consigne de densités de couleur ($D_Y$, $D_M$, $D_C$) associées aux grandeurs d'extrait de couleur (Y, M, C) des extraits de couleur colorés.

19. Procédé selon l'une des revendications 1 à 18, caractérisé en ce qu'on effectue la linéarisation de la densité de couleur du support-couleur (11) (selon la caractéristique c de la revendication 1):

$c_1$) on prédétermine des grandeurs de consigne, échelonnées, de densités de couleur ($D_Y$, $D_M$, $D_C$) et on les transforme en grandeurs de commande (r, g, b) pour l'unité d'inscription de couleur (13), les grandeurs de commande déterminant l'énergie lumineuse de la lumière colorée de l'unité d'inscription de couleur (13),

$c_2$) on inscrit des coins de couleur sur le support-couleur (11), à l'aide des grandeurs de commande (r, g, b),

$c_3$) on mesure les coins de couleur inscrits pour déterminer suivant la densité les grandeurs réelles et,

$c_4$) en même temps, on détermine à l'aide des coins de couleur, les grandeurs maximales de densités de couleur ($D_{Ymax}$, $D_{Mmax}$, $D_{Cmax}$) nécessaires pour obtenir la plus grande saturation de couleur possible sur le support-couleur (11).

20. Procédé selon l'une des revendications 1 à 19, caractérisé en ce que pour l'inscription de l'image en couleur, on utilise de la lumière-laser.

21. Montage pour l'inscription d'image en couleur sur un support-couleur à l'aide d'une lumière à répartition spectrale déterminée pour les contrôles de qualité dans une impression polychrome, caractérisé par:

a) un circuit de commande (12) pour générer les grandeurs de commande (r, g, b) à partir des grandeurs d'extrait de couleur (Y, M, C, K), unité composée de:

$a_1$) un convertisseur de couleur (16) qui reçoit les grandeurs d'extrait de couleur pour générer des grandeurs de densités de couleur ($D_Y$, $D_M$, $D_C$) à partir des grandeurs d'extrait de couleur, les grandeurs de densités de couleur étant une mesure pour l'inscription de l'image en couleur, avec équivalence de couleur pour les densités de couleur nécessaires sur le support-couleur,

$a_2$) un étage de linéarisation (17) qui est relié au convertisseur de couleur (16) pour linéariser la densité de couleur du support-couleur,

$a_3$) un convertisseur numérique/analogique (19) relié à l'étage de linéarisation (17) pour convertir les grandeurs de densités de couleur, modifiées par la linéarisation de densités de couleur en des grandeurs de commande, et

b) une unité d'inscription de couleur (13) qui est reliée au circuit de commande (12) et qui se compose de:

$b_1$) au moins une source lumineuse (32, 33, 34) pour générer de la lumière à trois composantes de spectre,

$b_2$) des modulateurs de lumière (38, 39, 40) placés dans le chemin optique et qui reçoivent des grandeurs de commande pour modifier l'intensité des trois composantes de spectre en fonction des grandeurs de commande,

$b_3$) des moyens optiques (56, 57, 58, 60) pour focaliser la lumière sur le support-couleur (11), et par

c) un support d'inscription (14) pour le support-couleur (11) et qui est mobile par rapport à l'unité d'inscription de couleur (13).

22. Montage selon la revendication 21, caractérisé en ce qu'un étage de gradation (15) est prévu en amont du convertisseur de couleur (16) pour modifier les grandeurs d'extrait de couleur suivant une courbe de gradation dépendant du procédé d'impression utilisé ultérieurement.

23. Montage selon la revendication 21 ou 22, caractérisé en ce que le convertisseur de couleur (16) se compose des éléments suivants:

a) un dispositif d'association (21) pour les grandeurs de densités de couleur ($D_Y$, $D_M$, $D_C$) et les grandeurs d'extrait de couleur (Y, M, C),

b) un calculateur de grandeurs de noir (23) pour calculer les grandeurs de noir à partir des grandeurs d'extrait de couleur (K) pour l'extrait de couleur noir, et

c) un étage de superposition (24) qui est relié à l'installation d'association (21) et au calculateur de grandeurs de noir (23) pour superposer les grandeurs de densités de couleur ($D_Y$, $D_M$, $D_C$) et les grandeurs de noir, calculées.

24. Montage selon la revendication 23, caractérisé en ce que l'installation d'association (21) se compose d'une mémoire d'association pour les grandeurs de densités de couleur ($D_Y$, $D_M$, $D_C$) et les grandeurs d'extrait de couleur (Y, M, C) et un étage d'interpolation.

25. Montage selon l'une des revendications 21 à 24, caractérisé en ce que le circuit de commande (12) comporte un générateur de coins de couleur (20) qui peut être relié à l'étage de linéarisation (17) pour appeler les grandeurs de densités de couleur pour éclairer les coins de couleur sur le support-couleur.

26. Montage selon l'une des revendications 21 à 25, caractérisé en ce que la source de lumière est au moins un laser.

Fig. 1

0 096 090

Fig.2

*Fig. 3a*

*Fig. 3b*

Fig. 4a

Fig. 4b

Fig. 5a

Fig. 5b

Fig. 5c

Fig. 5d

Fig. 5e

Fig. 5f